# EUROPEAN PATENT SPECIFICATION

(11) **EP 0 904 954 B1**
(45) Date of publication and mention of the grant of the patent: **02.04.2003**
(21) Application number: 98118359.3
(22) Date of filing: 29.09.1998
(51) Int. Cl.: B41N 3/03

(54) **Positive working photosensitive lithographic printing plate**
Positiv arbeitende lithographische Druckplatte
Planche d'impression lithographique de type positif

(30) Priority: 29.09.1997 JP 26430997
(43) Date of publication of application: 31.03.1999
(73) Proprietor: FUJI PHOTO FILM CO., LTD., Kanagawa-ken (JP)
(72) Inventor: Hotta, Hisashi, Yoshida-cho, Haibara-gun, Shizuoka (JP); Kitada, Kazuyuki, Yoshida-cho, Haibara-gun, Shizuoka (JP)
(74) Representative: HOFFMANN - EITLE

(56) References cited:
- EP-A- 0 110 417
- EP-A- 0 154 200
- EP-A- 0 490 231
- EP-A- 0 565 006
- EP-A- 0 689 941
- DE-A- 3 232 485
- FR-A- 2 380 147
- US-A- 5 556 531
- DATABASE WPI Section Ch, Week 9309 Derwent Publications Ltd., London, GB; Class A89, AN 93-070709 XP002092987 & JP 05 016558 A (FUJI PHARM IND CO LTD) , 26 January 1993
- PATENT ABSTRACTS OF JAPAN vol. 014, no. 464 (M-1033), 9 October 1990 & JP 02 185493 A (FUJI PHOTO FILM CO LTD), 19 July 1990
- PATENT ABSTRACTS OF JAPAN vol. 098, no. 005, 30 April 1998 & JP 10 020506 A (FUJI PHOTO FILM CO LTD), 23 January 1998
- PATENT ABSTRACTS OF JAPAN vol. 098, no. 008, 30 June 1998 & JP 10 062972 A (KONICA CORP), 6 March 1998
- DATABASE WPI Section Ch, Week 9820 Derwent Publications Ltd., London, GB; Class A89, AN 98-221277 XP002092988 & JP 10 062973 A (KONICA CORP) , 6 March 1998

## Description

### FIELD OF THE INVENTION

The present invention relates to a photosensitive lithographic printing plate and, more particularly, to a positive working photosensitive lithographic printing plate.

### BACKGROUND OF THE INVENTION

The positive working photosensitive lithographic printing plate (hereinafter referred to as "a positive working presensitized plate") which has prevailingly used to date is a presensitized plate having, on an aluminum support previously roughened at the surface, etched with alkali, if needed, and further anodized, a positive working photosensitive layer comprising an o-quinonediazide compound. The o-quinonediazide compounds are known to be converted into carboxylic acids by irradiation with ultraviolet rays. Therefore, by development with an aqueous alkali after imagewise exposure, the photosensitive layer of the foregoing type is dissolved and removed in the exposed area alone to bare the support surface. Thus, the lipophilic photosensitive layer remains in the unexposed area (image area), and thereby an ink-receptive area is formed; while the water-wettable support surface is bared in the exposed area (non-image area), and the bared area of the support surface keeps water to become an ink repelling area.

However, the surface of an aluminum support is insufficient in water wettability; as a result, it cannot have sufficient ink repulsion, thereby causing a trouble that ink adheres to the non-image area (this property is hereinafter referred to as "liability to scumming").

Accordingly, it is necessary for the non-image area to be rendered wettable with water for the purpose of reducing the liability to scumming. Usually, the water wettability is conferred on the non-image area alone by using a developer containing an alkali metal silicate at the time of development, thereby lessening the liability to scumming. However, the use of the developer containing an alkali metal silicate arises a trouble that a solid matter attributed to SiO₂ tends to separate out or the presence of SiO₂ causes gelation in a neutralization treatment upon the disposal of the waste developer.

As a developer which can avoid such troubles, a developer containing, besides an alkali agent, at least one compound selected from saccharides, oximes, phenols or fluorinated alcohols as a development stabilizer in a concentration of at least 0.01 mole/ℓ, namely a silicate-free developer, is considered to be usable. However, the development of a conventional positive working presensitized plate with such a silicate-free developer has other disadvantages that the anodized layer of an aluminum support is dissolved and accumulated in the developer to give rise to dregs and sludge; as a result, the automatic developing machine suffers deterioration in cleaning performance, the sprays installed therein are clogged, and so on.

Further, the development of an anodized substrate with a silicate-free developer adjusted to pH 10-13.2 has a problem that the dissolution of the anodized layer upon development renders the non-image area white. Furthermore, when the plate is allowed to stand after receiving a printing operation, ink comes to be difficult to remove. This phenomenon is referred to as standing stain.

Hitherto, various treatments for the anodized layer of a substrate have been proposed. The steam treatment which is said to have an ability to prevent the anodized layer from dissolving upon development can inhibit the whitening of the non-image area, but cannot solve the problem of standing stain. On the other hand, the silicate treatment for the anodized layer can solve the problem of whitening in the non-image area and the problem of standing stain, but it has a drawback of giving rise to deterioration in impression capacity.

Therefore, it has been expected to develop the art of ensuring satisfactory adhesion force between a substrate and a photosensitive layer and causing no deterioration in press life even when the substrate having a surface previously rendered wettable with water is coated with a positive working photosensitive layer.

With the intention of solving the various problems as mentioned above, U.S. Patent 3,136,636 proposes providing an intermediate layer of water-soluble polymer, such as polyacrylic acid or carboxylmethylhydroxyethyl cellulose. However, this art is still unsatisfactory in impression capacity. On the other hand, U.S. Patent 4,483,913 proposes providing an interlayer of quaternary ammonium compound, such as poly(dimethyldiallylammonium chloride), but this art is also unsatisfactory in reduction of liability to scumming.

### SUMMARY OF THE INVENTION

Therefore, an object of the present invention is to provide a positive working presensitized plate having a high impression capacity and substantial reduction in liability to scumming.

Another object of the present invention is to provide a positive working presensitized plate which, even when it is developed with an alkali metal silicate-free developer, can ensure the prevention of whitening in the non-image area and the inhibition of dregs and sludge generation in the developer as well as a high impression capacity and substantial reduction in liability to scumming.

As a result of our intensive studies made for attaining the aforementioned objects, it has been found that a positive working presensitized plate having a satisfactory impression capacity and a substantial reduction in liability to scumming and ensuring the prevention of whitening in the non-image area and the inhibition of dregs and sludge generation in the developer can be obtained when, in the preferred treatment with an aqueous solution of alkali metal silicate for rendering the aluminum support surface wettable with water in the preparation of a positive working presensitized plate, the amount of Si atoms attached to the aluminum support surface is controlled to a specific range. In other words, it has been found that, with respect to the amount of Si atoms attached to the surface of an aluminum support, there is a specific range which enables the resulting positive working presensitized plate to have satisfactory impression capacity and materially reduced liability to scumming and, at the same time, to be inhibited from whitening in the non-image area and from giving rise to dregs and sludge in the developer.

More specifically, the present invention relates to a presensitized plate comprising an aluminum support and a positive working photosensitive layer, wherein the amount of Si atoms attached to the aluminum support surface is in the range of 0.1 to 8 mg/m².

In accordance with the present invention, a positive working presensitized plate which is materially reduced in liability to scumming and has a satisfactory impression capacity can be obtained. Further, not only the whitening of the non-image area upon development but also the generation of dregs and sludge in a developer used can be prevented. Furthermore, the embodiments according to the present invention are smaller in the amount of Si atoms attached to the aluminum support than those which have so far been adopted in practice, and the treatment conditions in the present invention are mild, specifically the treatment temperature is low, the treatment time is short and the treatment solution concentration is low, compared with those hitherto employed in practice. Therefore, the hydrophilic treatment, which is preferably carried out with an alkali metal silicate, which is employed in the present invention has an economic advantage over the conventional hydrophilic treatment with an alkali metal silicate.

In addition, the Inventors have found that, when an interlayer comprising a high molecular compound having acid group-containing constitutional units is provided on the Si-attached aluminum support of a positive working presensitized plate according to the present invention and on this interlayer a positive working photosensitive layer is provided, the adhesion force between the positive working photosensitive layer and the aluminum support can be increased more, so that the positive working presensitized plate obtained can have the higher impression capacity and the higher chemical resistance (the term "chemical resistance" as used herein refers to the number of normal prints obtained by printing operations performed while wiping the image with a plate cleaner).

Also, the Inventors have found that, when the polymeric compound which constitutes the interlayer comprises not only an acid group-containing constitutional unit but also an onium group-containing constitutional units, the acid group can further elevate the adhesion force between the positive working photosensitive layer and the aluminum support which is previously rendered wettable with water by the treatment, to thereby produce improvements in impression capacity and chemical resistance of the resulting positive working presensitized plate and, what is more, the interlayer is easily dissolved upon development and removed from the support surface since the acid groups are easily dissociated by an alkali developer at the time of development, so that the water receptive support surface is more likely to be bared and thereby the liability to scumming is reduced more, and further the synergistic effect produced by the onium group and the acid group can reduce color stains (the extent to which the dyes added into the photosensitive layer remains on the non-image area of the support after development) and can improve the printing-out property (the difference in optical density between the exposed area and the unexposed area before development).

### DETAILED DESCRIPTION OF THE INVENTION

The constituent elements of a positive working presensitized plate according to the present invention, specifically a support, an interlayer and a positive working photosensitive layer, and the development processing for the present positive working presensitized plate are illustrated below in detail in that order.

### [1] Support

In the first place, the support used for the present positive working presensitized plate and treatments therefor are illustrated.

### Aluminum Plate

The aluminum plate used in the present invention is a plate-form pure aluminum, a plate-form aluminum alloy containing trace amounts of foreign atoms, or the like.

Such foreign atoms include silicon, iron, manganese, copper, magnesium, chromium, zinc, bismuth, nickel, titanium and so on. The appropriate content of foreign atoms in such an aluminum alloy is 10 % by weight or below. The aluminum for the present invention is preferably pure aluminum, but the completely pure aluminum is difficult to produce from the viewpoint of scouring technique. Although it is desirable to use an aluminum plate containing foreign atoms in the lowest possible amounts, the aluminum alloy plate in which foreign atoms are present to the extent of 10 % by weight or less can be used as a support material of the present invention. Therefore, the aluminum plate used in the present invention has no particular restriction as to its composition, but any of well-known, generally used materials may be employed properly. Examples of a desirable material include JIS A 1050, JIS A 1100, JIS A 1200, JIS A 3003, JIS A 3103 and JIS A 3005. The thickness of an aluminum plate used is from about 0.1 mm to about 0.6 mm. Prior to the surface roughening treatment of an aluminum plate, the aluminum plate is subjected to a degreasing treatment with, e.g., a surfactant or an alkaline aqueous solution in order to remove a rolling oil from the surface of the aluminum plate, if needed.

### Surface Roughening Treatment and Anodic Oxidation Treatment

In general the aluminum plate as mentioned above is first subjected to a surface roughening treatment. The surface roughening treatment can be effected by adopting a method of mechanically roughening the surface, a method of electrochemically dissolving the surface or a method of performing selective dissolution of the surface with a chemical means. As the method of mechanically roughening the surface, known methods including a ball abrasion method, a brush abrasion method, a blast abrasion method and a buff abrasion method can be adopted. As for the method of electrochemically roughening the surface, there is a method of soaking an aluminum plate in a hydrochloric or nitric acid electrolyte and passing therethrough a direct or alternating electric current to render the plate surface rough. Also, the above-cited mechanically and electrochemically roughening methods can be used in combination, as disclosed in JP-A-54-63902 (the term "JP-A" as used herein means an "unexamined published Japanese patent application").

The thus roughened aluminum plate undergoes an alkali etching treatment and a neutralizing treatment, if needed, and then it is subjected to an anodic oxidation treatment for the purpose of heightening the water retentivity and the abrasion resistance at the surface. For the anodic oxidation treatment of the aluminum plate, any electrolyte can be used as far as it can form a porous oxidized film on the aluminum plate. In general, sulfuric acid, phosphoric acid, oxalic acid, chromic acid or a mixture of two or more thereof can be used as the electrolyte. The electrolyte concentration can be properly chosen depending on the species of the electrolyte used.

The conditions under which the anodic oxidation is carried out vary depending on the electrolyte used, and so it is difficult to specify the conditions. In general, however, effective anodic oxidation can be achieved so far as the concentration of an electrolytic solution used is from 1 to 80 % by weight, the solution temperature is from 5°C to 70°C, the electric current density is from 5 to 60 A/dm², the voltage is from 1 to 100 V and the electrolysis time is from 10 seconds to 5 minutes.

The suitable coverage of the anodized layer thus formed is at least 1.0 g/m², preferably from 2.0 to 6.0 g/m². When the coverage is less than 1.0 g/m², the impression capacity is liable to be insufficient, and the non-image area of the resulting lithographic printing plate is liable to be scratched, so that the so-called scratch stain, or the adhesion of ink to the scratched part upon printing, tends to generate.

Additionally, the support of a lithographic printing plate is subjected to such an anodic oxidation treatment on the side used for printing, but due to the extension of lines of electric force to the back side, the anodized layer having a coverage of from 0.01 to 3 g/m² is generally formed on the back surface also.

### Hydrophilic Treatment

The aluminum plate anodized in the aforementioned manner is preferably treated with an aqueous solution of alkali metal silicate, and thereby the anodized layer thereof is rendered wettable with water. Although this preferred treatment with an aqueous alkali metal silicate for conferring water wettability on the anodized layer can be effected using any of hitherto known various methods, the present invention requires in this case that the amount of alkali metal silicate attached to the aluminum support surface be controlled to the range of 0.1 to 8 mg/m², preferably 0.5 to 6 mg/m², particularly preferably 0.5 to 4 mg/m², based on the Si atoms. When the amount of the alkali metal silicate attached in this case is less than 0.1 mg/m² based on the Si atoms, it is too small to reduce the liability to scumming to the intended extent. In addition, in a case where the developer used is free from an alkali metal silicate, the whitening in the non-image area of a presensitized plate and the generation of dregs and sludge in the developer cannot be inhibited upon development. On the other hand, when the amount of the alkali metal silicate attached is increased beyond 8 mg/m² based on the Si atoms, the impression capacity becomes too low to attain the desired end.

In the present invention, the amount of an alkali metal silicate , which is preferably used in the present invention, attached to an aluminum support surface is determined as the amount of Si atoms (expressed in mg/m²) using an x-ray fluorescence spectrometer (XRF) and a calibration curve procedure. The standard sample for making the calibration curve is a sample formed by dropping an aqueous sodium silicate containing a known amount of Si atoms onto an aluminum plate so that it is uniformly spread within the area of 30 mm φ, followed by drying. In the examples described hereinafter, though the X-ray fluorescence spectrometer usable in the present invention has no particular restriction on the type, RIX 3000 made by Rigaku Corporation is used under the following condition, and the amount of Si atoms is determined from the peak height of Si-Kα spectrum;

| | |
|---|---|
| Apparatus | RIX 3000 made by Rigaku Corporation |
| X-ray tube | Rh |
| Spectrum measured | Si-Kα |
| Tube voltage | 50 kV |
| Tube current | 50 mA |
| Slit | COARSE |
| Analyzing crystal | RX4 |
| Detector | F-PC |
| Analysis area | 30 mmφ |
| Peak position (2θ) | 144.75 deg. |
| Background (2θ) | 140.70 deg., 146.85 deg. |
| Integration time | 80 sec/sample |

In carrying out the hydrophilic treatment, the treatment conditions including the concentration of an alkali metal silicate, which is preferably used in the hydrophilic treatment of the present invention, the treatment temperature and the treatment time, are properly selected so that the amount of Si atoms attached is in the specific range. More specifically, this treatment can be effected by dipping an anodized aluminum support for 0.5 to 120 seconds, preferably 2 to 30 seconds at 4 to 40°C in an aqueous solution containing preferably an alkali metal silicate in a concentration of from 0.001 to 30 % by weight, preferably from 0.01 to 10 % by weight, particularly preferably from 0.1 to 5 % by weight, and having a pH value of 10 to 13 at 25°C. When the aqueous solution of alkali metal silicate which is preferably used for this hydrophilic treatment is adjusted to a pH value lower than 10, the gelation thereof takes place; while, when the pH thereof is raised beyond 13.0, the anodized layer dissolves therein. Thus, care should be taken on the pH adjustment.

Examples of an alkali metal silicate preferably used in the present hydrophilic treatment include sodium silicate, potassium silicate and lithium silicate.

The aqueous solution of alkali metal silicate preferably used for the present hydrophilic treatment can be admixed with hydroxides, if needed, for the pH adjustment to the aforesaid range. Examples of hydroxide usable for such a purpose include sodium hydroxide, potassium hydroxide and lithium hydroxide.

Further, the present preferred aqueous solution of alkali metal silicate may be admixed with an alkaline earth metal salt or a Group IVB metal salt, if desired. Examples of such an alkaline earth metal salt include nitrates, such as calcium nitrate, strontium nitrate, magnesium nitrate and barium nitrate, and other water-soluble salts of alkaline earth metals, such as sulfates, hydrochlorides, phosphates, acetates, oxalates and borates of alkaline earth metals as recited above. Examples of a Group IVB metal salt include titanium tetrachloride, titanium trichloride, potassium titanium fluoride, potassium titanium oxalate, titanium sulfate, titanium tetraiodide, zirconium oxide chloride, zirconium dioxide, zirconium oxychloride and zirconium tetrachloride. Those alkaline earth metal salts or Group IVB metal salts can be used alone or as a mixture of two or more thereof. It is desirable that such a salt be used in a proportion of 0.01 to 10 % by weight, preferably 0.05 to 5.0 % by weight.

### Treatment with Acidic Aqueous Solution

In the present invention, the aluminum support which has undergone the foregoing hydrophilic treatment can be treated with an acidic aqueous solution, if needed. Such an acidic aqueous solution can be an aqueous solution of sulfuric acid, nitric acid, hydrochloric acid, oxalic acid, phosphoric acid or the like. This acidic aqueous solution treatment is appropriately carried out under a condition that the aluminum support rendered wettable with water is dipped in an aqueous solution having an acid concentration of 0.001 to 10 % by weight, preferably 0.01 to 1 % by weight, for 0.5 to 120 seconds, preferably 2 to 30 seconds, at 15 to 70°C, preferably 25 to 50°C. By the acidic aqueous solution treatment, the amount of alkali metal silicate that is preferably attached to the aluminum support by the hydrophilic treatment can be adjusted so that it is reduced properly.

### Backing Coat

On the back side of an aluminum support used in the present invention, a backing coat is provided, if needed. Suitable examples of such a backing coat include a coating of the organic high molecular compound as described in JP-A-5-45885 and coatings of the metal oxides prepared by hydrolysis and polycondensation of the organic or inorganic metallic compounds as described in JP-A-6-35174.

Of these coatings, the coatings of metallic oxides prepared from alkoxy compounds of silicon, such as Si(OCH₃)₄, Si(OC₂H₅)₄, Si(OC₃H₇)₄ and Si(OC₄H₉)₄, are preferred in particular because those alkoxy compounds are available at low prices and the coatings have high developer resistance.

### [2] Interlayer

On the aluminum support rendered wettable with water, or on the aluminum support rendered wettable with water and then treated with an acidic aqueous solution, a positive working photosensitive layer can be provided directly. Alternatively, it is also possible to provide an interlayer, if needed, and then provide a positive working photosensitive layer on the interlayer.

The high molecular compound usable for the formation of an interlayer is a high molecular compound comprising acid group-containing constitutional units. Further, it is preferable to use a high molecular compound having onium group-containing constitutional units in addition to acid group-containing constitutional units.

### Interlayer of High Molecular Compound having Acid Groups

Suitable exampled of an acid group contained in those constitutional units include acid groups having an acid dissociation constant (pKa) of 7 or below, preferably -COOH, -SO₃H, -OSO₃H, -PO₃H₂, -OPO₃H₂, -CONHSO₂- and -SO₂NHSO₂-, particularly preferably -COOH.

The suitable acid group-containing constitutional units are constitutional units derived from polymerizing compounds of the following formula (1) or (2): 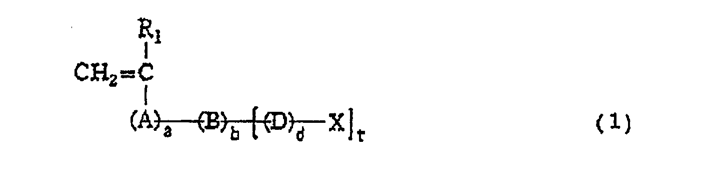 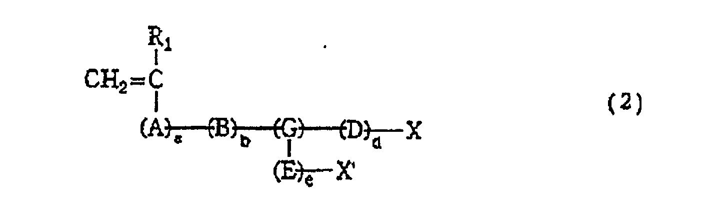 wherein A represents a divalent linkage group, B represents an unsubstituted or substituted aromatic group, D and E each independently represent a divalent linkage group, G represents a trivalent linkage group, X and X' each independently represent an acid group having pKa of 7 or below or an alkali metal salt thereof, R₁ represents a hydrogen atom, an alkyl group or a halogen atom, a, b, d and e are each 0 or 1, and t is an integer of 1 to 3.

Of these compounds providing acid group-containing constitutional units, preferred compounds are those represented by the foregoing formulae (1) and (2) wherein A is -COO- or-CONH-, B is an unsubstituted phenylene group or a phenylene group substituted with a hydroxyl group, a halogen atom or an alkyl group, D and E each independently represent an alkylene group or a divalent linkage group represented by formula CₙH₂ₙO, CₙH₂ₙS or CₙH₂ₙ₊₁N, G represents a trivalent linkage group represented by formula CₙH₂ₙ₋₁, CₙH₂ₙ₋₁O, CₙH₂ₙ₋₁S or CₙH₂ₙN wherein n is an integer of from 1 to 12, X and X' are each a carboxylic acid group, a sulfonic acid group, a phosphonic acid group, a sulfuric acid monoester group or a phosphonic acid monoester group, R₁ is a hydrogen atom or an alkyl group, and a, b, d and e are each 0 or 1, provided that the case of a=b=0 is excluded.

The acid group-containing constitutional units preferred in particular are those derived from compounds represented by the foregoing formula (1) wherein B is an unsubstituted phenylene group or a phenylene group substituted with a hydroxyl group or an alkyl group having 1 to 3 carbon atoms, D is an alkylene group having 1 to 2 carbon atoms or a divalent linkage group of formula -CₙH₂ₙO- or -OCₙH₂ₙ- wherein n is 1 or 2, R₁ is a hydrogen atom or a methyl group, X is a carboxylic acid group, a is 0 and b is 1.

Examples of the acid group-containing constitutional unit are illustrated below, but these examples should not be construed as limiting the scope of the invention in any way.

Besides acrylic acid, methacrylic acid, crotonic acid, isocrotonic acid, itaconic acid, maleic acid and maleic anhydride, the following compounds are included in such examples:

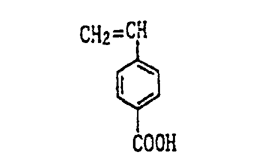

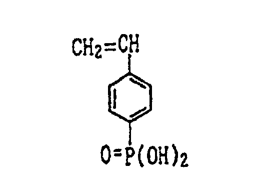

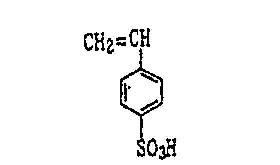

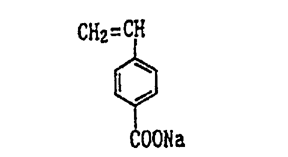

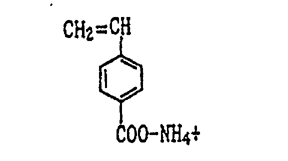

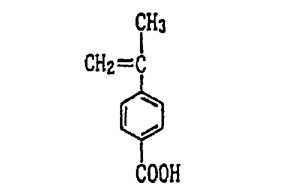

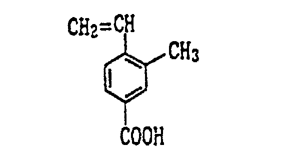

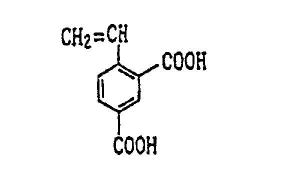

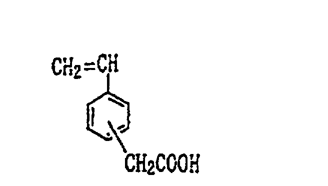

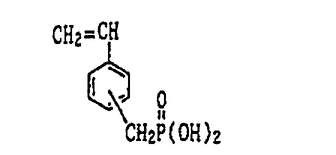

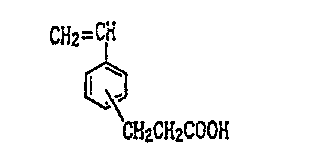

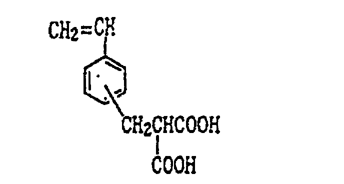

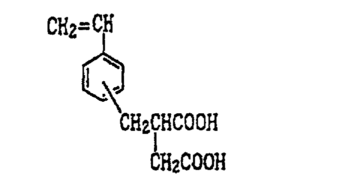

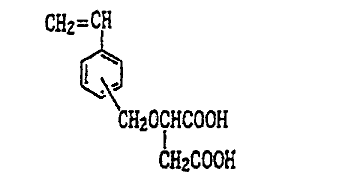

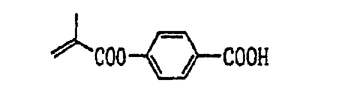

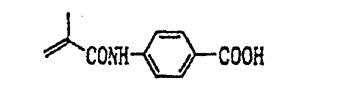

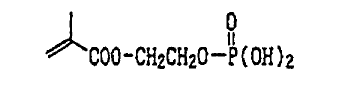

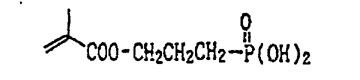

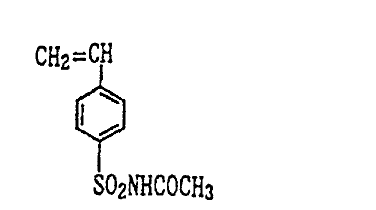

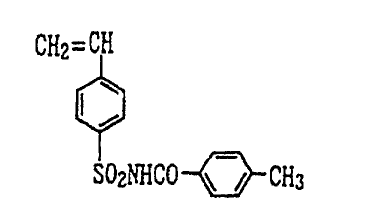

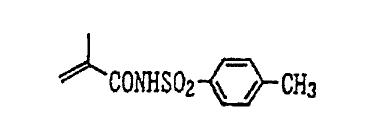

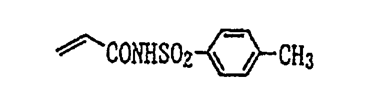

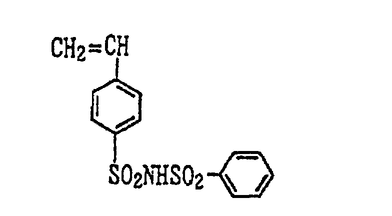

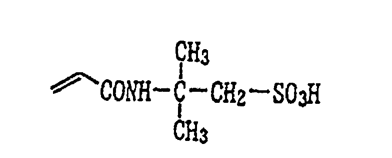

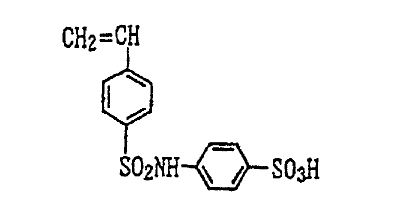

The acid group-containing constitutional units as illustrated above can be used alone or in combination with two or more thereof.

### Interlayer of High Molecular Compound having Onium groups in addition to Acid Groups

Suitable examples of an onium group contained in the constitutional units of a high molecular compound used for the formation of an interlayer include an onium group comprising a Group V or Group VI atom, preferably an onium group comprising a nitrogen, phosphorus or sulfur atom, particularly preferably an onium group comprising a nitrogen atom.

It is desirable for such a high molecular compound having an onium group to have the main-chain structure of a vinyl polymer such as acrylic resin, methacrylic resin or polystyrene, that of an urethane resin, that of polyester, or that of polyamide. In particular, the main-chain structure of a vinyl polymer, such as an acrylic resin, a methacrylic resin or a polystyrene, is preferred over the others.

Particularly preferred high molecular compounds are polymerizable compounds in which the constitutional unit having an onium group is one represented by the following formula (3), (4) or (5). 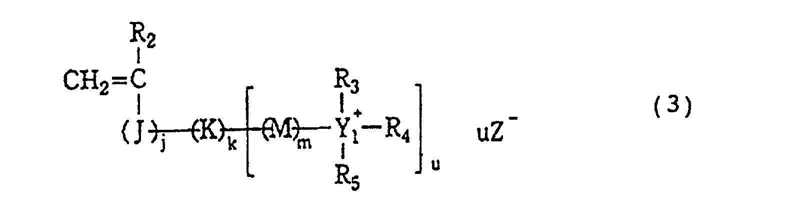 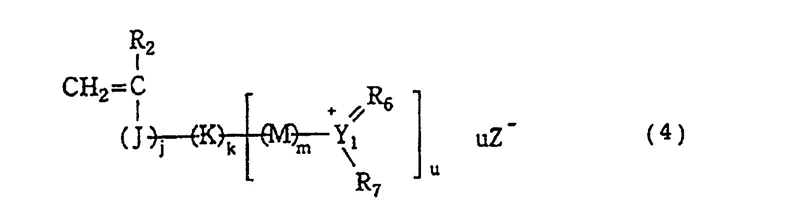 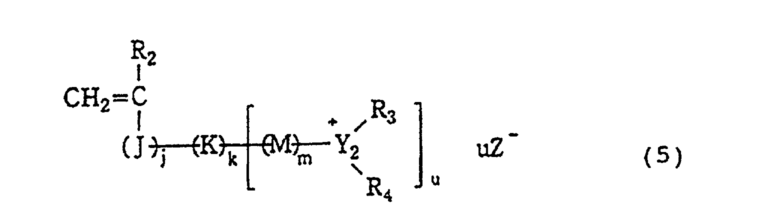 wherein J represents a divalent linkage group, K represents an unsubstituted or substituted aromatic group, M represents a divalent linkage group, Y₁ represents a Group V atom, Y₂ represents a Group VI atom, Z⁻ represents a counter anion, R₂ represents a hydrogen atom, an alkyl group or a halogen atom, R₃, R₄, R₅ and R₇ each independently represents a hydrogen atom, or an alkyl, aromatic or aralkyl group which may have a substituent, R₆ represents an unsubstituted or substituted alkylidene group, or wherein the combination of R₃ and R₄ or that of R₆ and R₇ may form a ring, j, k and m each independently represents 0 or 1, and u represents an integer of from 1 to 3.

Of these compounds which can provide onium group-containing constitutional units, preferable compounds are those represented by the foregoing formulae (1) and (2) wherein J is -COO- or -CONH-, K is ah unsubstituted phenylene group or a phenylene group substituted with a hydroxyl group, a halogen atom or an alkyl group, M is an alkylene group or a divalent linkage group represented by formula CₙH₂ₙO, CₙH₂ₙS or CₙH₂ₙ₊₁N wherein n is an integer of from 1 to 12, Y₁ is a nitrogen atom or a phosphorus atom, Y is a sulfur atom, Z⁻ is a halogen ion, PF₆⁻, BF₄⁻ or R₈SO₃⁻ (wherein R₈ is an alkyl, aromatic or aralkyl group which have 1 to 10 carbon atoms), R₂ is a hydrogen atom or an alkyl group, R₃, R₄, R₅ and R₇ each independently represents a hydrogen atom or an alkyl, aromatic or aralkyl group which have 1 to 10 carbon atoms and may have substituent(s), R₆ is an unsubstituted 1-10C alkylidene group or a substituted alkylidene group, or wherein the combination of R₃ and R₄ or that of R₆ and R₇ may form a ring, j, k and m each are independently 0 or 1, provided that the case of j=k=0 is excluded.

The onium group-containing constitutional units preferred in particular are those derived from compounds represented by the foregoing formula (3), (4) or (5) wherein K is an unsubstituted phenylene group or a phenylene group substituted with a hydroxyl group or an alkyl group having 1 to 3 carbon atoms, M is an alkylene group having 1 to 2 carbon atoms or a divalent linkage group of formula CₙH₂ₙO wherein n is 1 or 2, Z⁻ is Cl⁻ or R₈SO₃⁻ (wherein R₈ is an alkyl, aromatic or aralkyl group which have 1 to 10 carbon atoms), R₂ is a hydrogen atom or a methyl group, j is 0 and k is 1.

Examples of the onium group-containing constitutional unit are illustrated below, but these examples should not be construed as limiting the scope of the invention in any way.

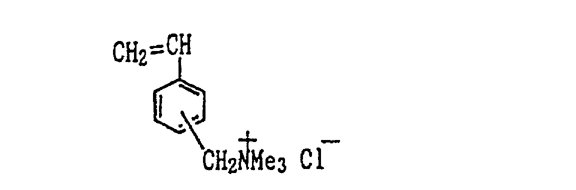

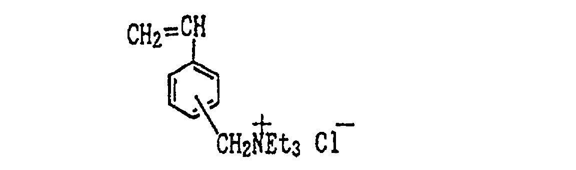

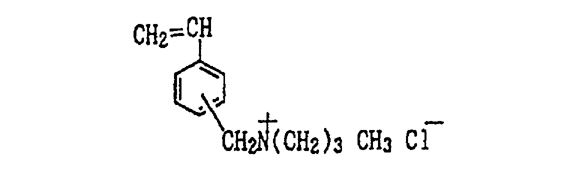

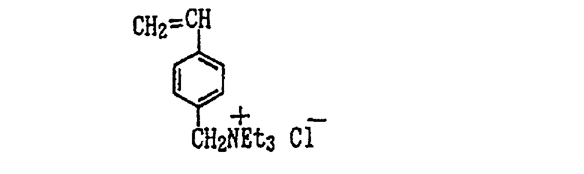

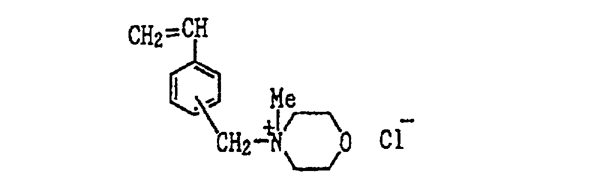

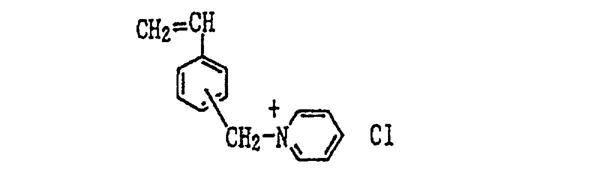

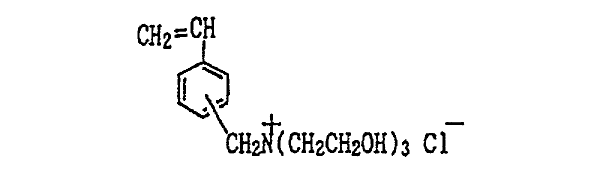

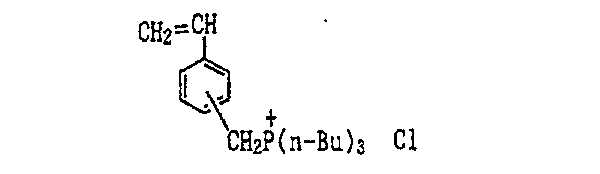

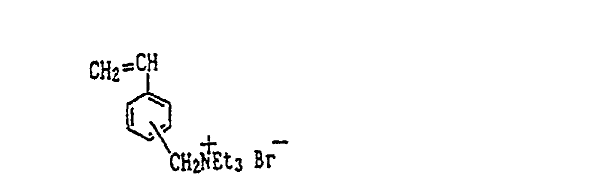

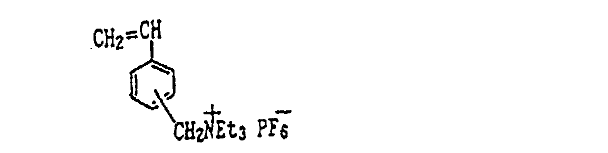

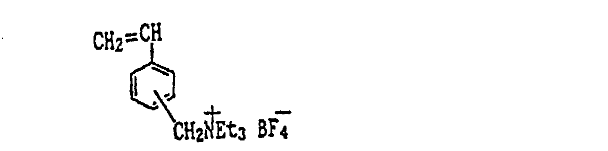

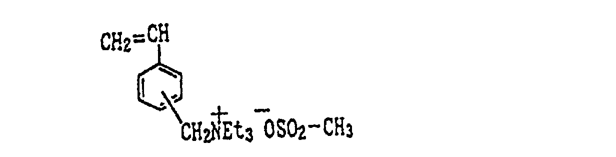

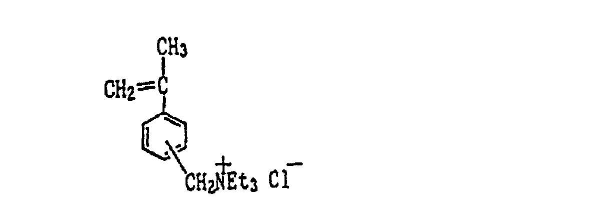

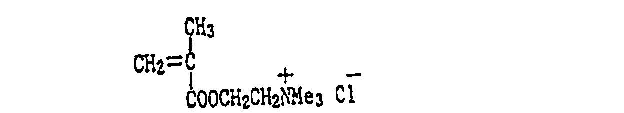

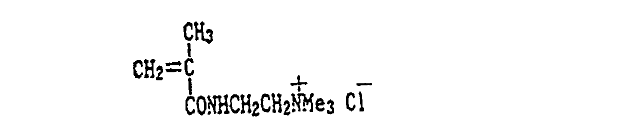

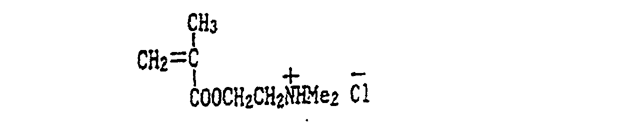

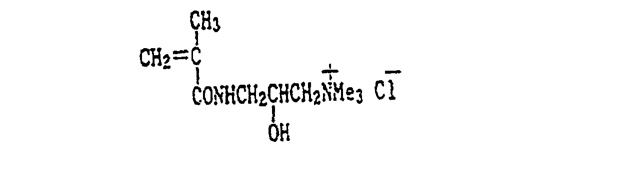

For the high molecular compound used for the formation of an interlayer, it is desirable to have onium group-containing constitutional units as illustrated above in a proportion of at least 1 mole %, preferably at least 5 mole %. When the onium group-containing constitutional units is contained in a proportion of at least 1 mole %, the resulting interlayer can have more improved adhesiveness.

Also, the onium group-containing constitutional units may be employed alone or in combination of two or more thereof. In addition, two or more of the foregoing type of high molecular compounds differing in species or proportions of constitutional units or in molecular weight may be used as a mixture for the formation of the interlayer.

Further, in the high molecular compound having acid groups and onium groups beside, it is desirable that the proportion of acid group-containing constitutional units be at least 20 mole %, preferably at least 40 mole%, and the proportion of onium group-containing constitutional units be at least 1 mole %, preferably at least 5 mole %. When the proportion of acid group-containing constitutional units is 20 more % or more, the removal of the resulting interlayer by dissolution upon alkali development is more accelerated, and the synergistic effect produced by acid and onium groups can further heighten the adhesiveness of the resulting interlayer. Also, it is a matter of course that two or more of high molecular compound having onium groups as well as acid groups but differing in species or proportions of constitutional units or in molecular weight may be used as a mixture. Other monomers can be used in combination with an acid group-containing monomer and an onium group-containing monomer. Examples of the other monomers include those exemplified later as families (1) to (14) for the binder which can be preferably incorporated in the photosensitive layer.

Typical examples of a high molecular compound usable in the present invention are illustrated below. Additionally, the proportions of constitutional units in each polymer structure are expressed in mole %.

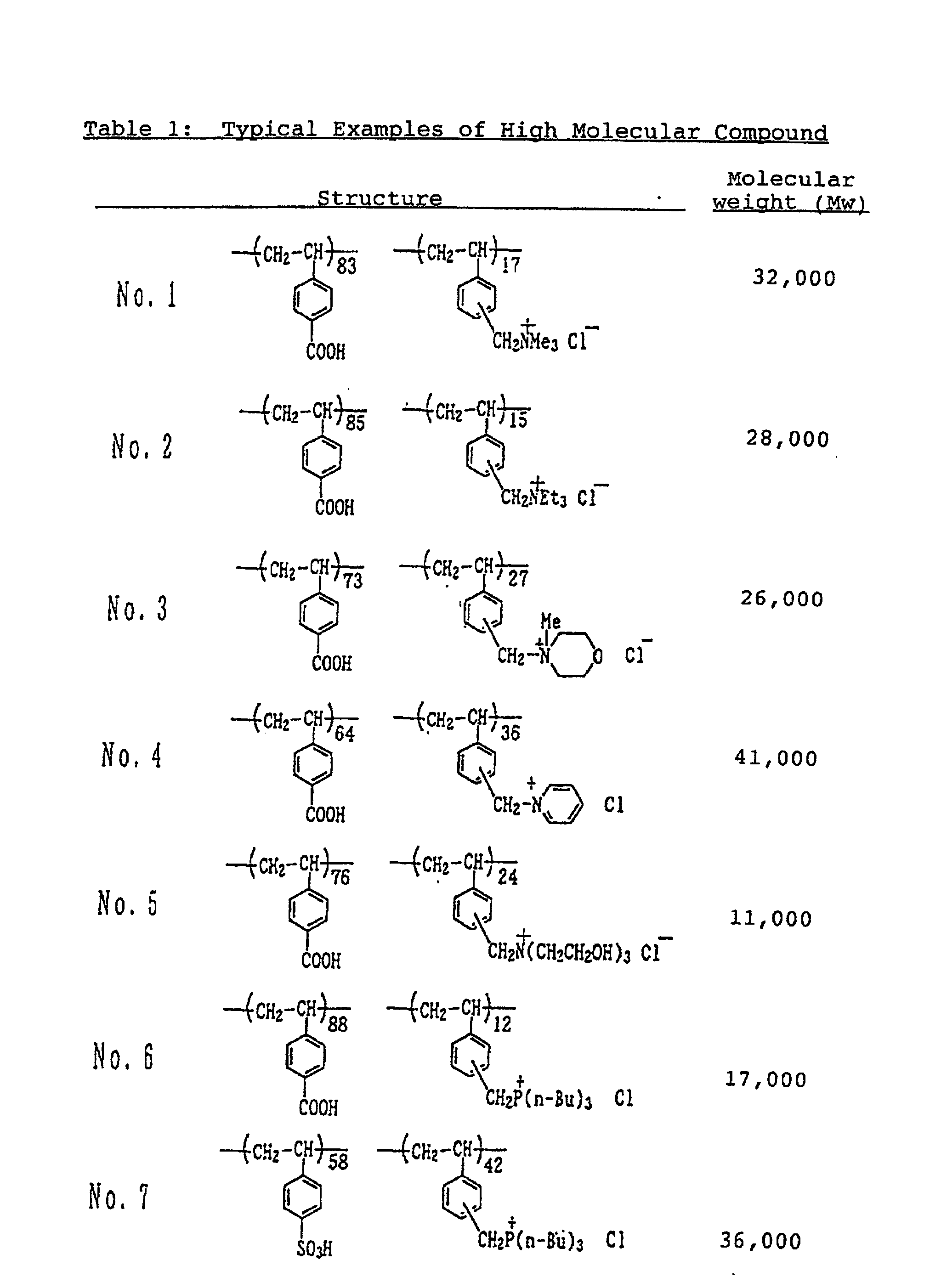

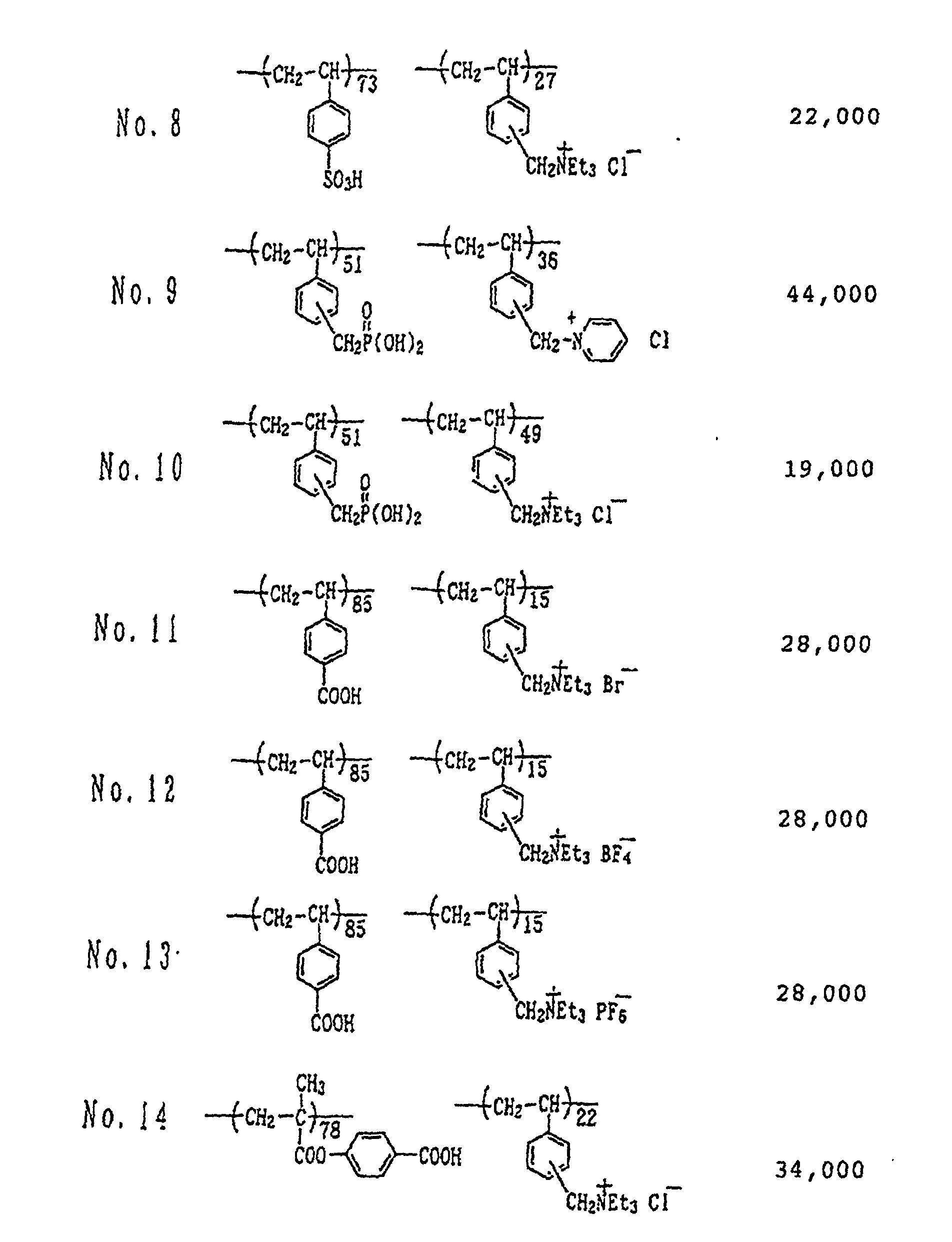

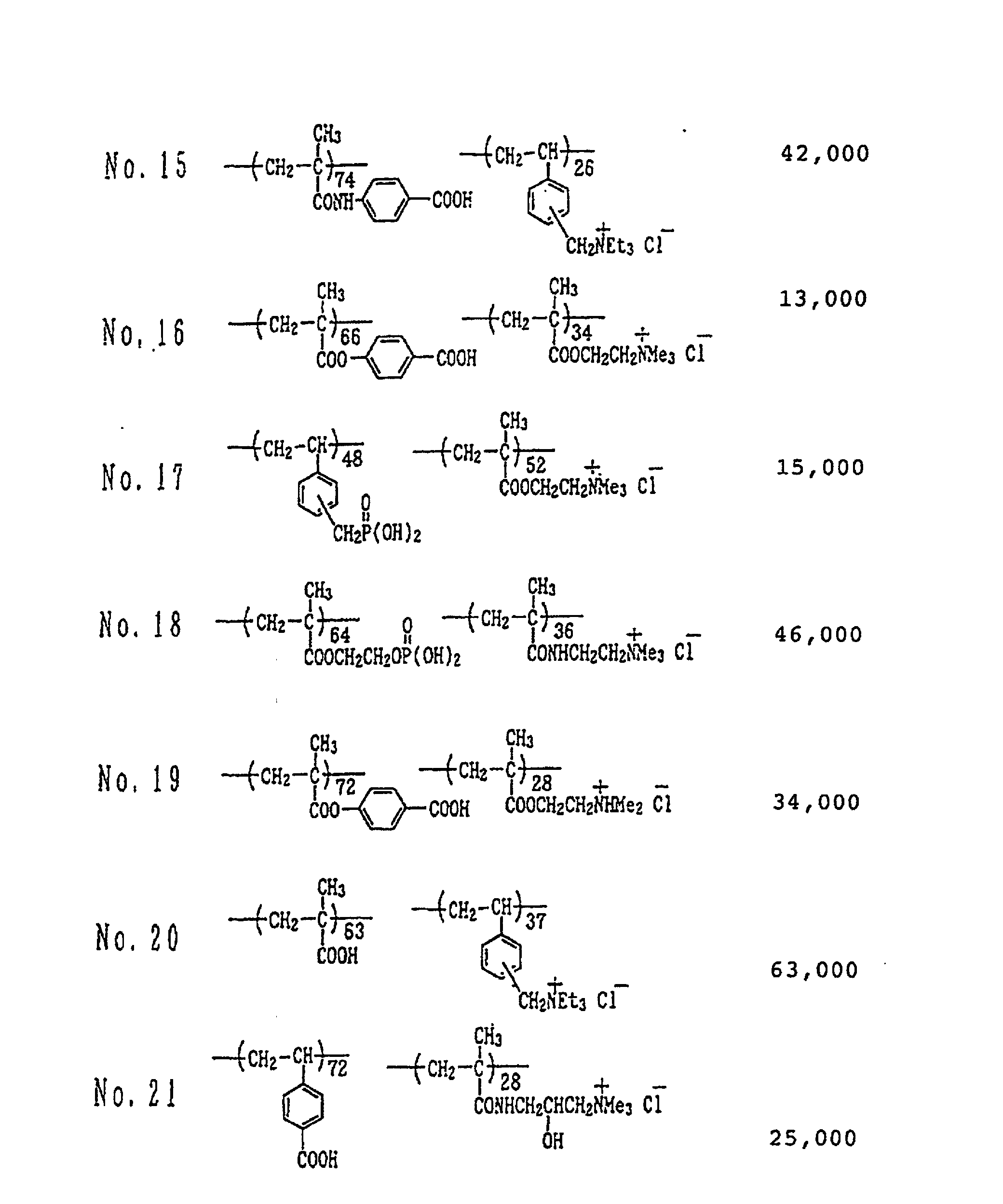

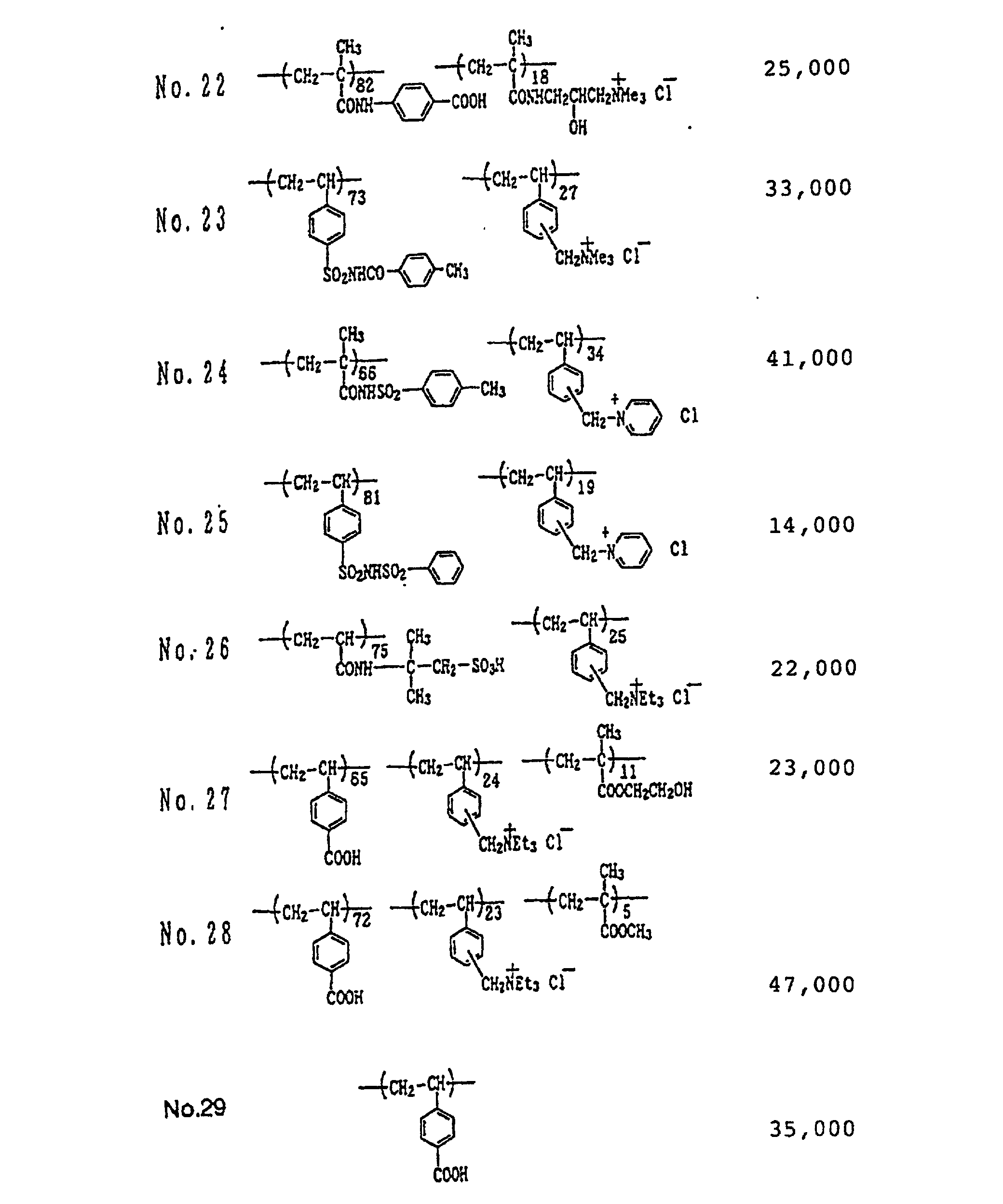

### Preparation of High Molecular Compound for Formation of Interlayer, and Molecular Weight Thereof

In general, any of high molecular compounds having acid groups and any of those having not only acid groups but also onium groups, which can be used for the interlayer formation as mentioned above, can be prepared according to a radical chain polymerization method (See F.W. Billmeyer, Textbook of Polymer Science, 3rd ed., A Wiley-Interscience Publication (1984)).

The molecular weight of such a high molecular compound may be in a wide range, but it is desirable that the weight average molecular weight (Mw) be in the range of 500 to 2,000,000, preferably 2,000 to 600,000, measured by the light scattering method. In addition, the content of unreacted monomers in the high molecular compound obtained as a reaction product, although it may be in a wide range, is desirably 20 % by weight or below, more desirably 10 % by weight or below.

As a preparation example of a typical high molecular compound having not only acid groups but also onium groups, the preparation of the copolymer of p-vinylbenzoic acid and vinylbenzyltrimethylammonium chloride shown as No.1 in Table 1 is described below.

In a 1-liter three necked flask were placed 146.9 g (0.99 mole) of p-vinylbenzoic acid (available from Hokko Chemical Industry Co., Ltd.), 44.2 g (0.21 mole) of vinylbenzyltrimethylammonium chloride and 446 g of 2-methoxyethanol. These compounds were heated with stirring in a stream of nitrogen, and kept at 75°C. Thereto, 2.76 g (12 mmole) of dimethyl 2,2-azobis(isobutyrate) was added, and the stirring was continued. After 2 hours, 2.76 g (12 mmmole) of dimethyl 2,2-azobis(isobutyrate) was further added. After 2 hours, 2.76 g (12 mmmole) of dimethyl 2,2-azobis(isobutyrate) was further added. Then, the stirring was continued for 2 hours, followed by cooling the reaction mixture to room temperature. The reaction mixture cooled was poured into 2 liter of ethyl acetate with stirring. The solid matter thus precipitated was filtered off, and dried to give 189.5 g of the intended copolymer. The weight average molecular weight (Mw) of the solid product was 32,000, measured by the light scattering method.

Other high molecular compounds can be prepared in the same process as described above.

### Formation of Interlayer

The interlayer is formed by coating a high polymer compound which has, as mentioned above, acid groups or not only acid groups but also onium groups (hereinafter referred simply as "high polymer compound") on the foregoing aluminum support which has undergone a hydrophilic treatment or the foregoing aluminum support which has undergone a hydrophilic treatment and further the treatment with an acidic aqueous solution (hereinafter referred simply to as "the aluminum support"). Therein, various coating methods can be adopted.

In one method generally adopted for forming the interlayer, a solution of an organic solvent containing a high molecular compound dissolved therein is coated on the aluminum support and then dried. In another method, the aluminum support is immersed in a solution of an organic solvent containing a high molecular compound dissolved therein, cleaned with water and then dried, so that the high molecular compound is made to adsorb on the aluminum support. Examples of the useful organic solvent include methanol, ethanol, methyl ethyl ketone, a mixture of two or more of these solvents, or a mixture of such an organic solvent with water. The solution used in the former method ranges in concentration from 0.005 to 10 % by weight, and can be coated using any of various techniques, including bar coater, spin, spray and curtain coating techniques. In the latter method, the solution ranges in concentration from 0.01 to 20 % by weight, preferably from 0.05 to 5 % by weight, the dipping temperature is from 20 to 90°C, preferably from 25 to 50°C, and the dipping time is from 0.1 second to 20 minutes, preferably from 2 seconds to 1 minute.

The foregoing solution of high molecular compound can be used in the pH range of from 0 to 12, preferably from 0 to 5. For this pH adjustment, various substances can be used. Examples thereof include basic substances (e.g., ammonia, triethylamine, potassium hydroxide), inorganic acids (e.g., hydrochloric acid, phosphoric acid, sulfuric acid, nitric acid), organic acidic substances, such as organic sulfonic acids (e.g., nitrobenzenesulfonic acid, naphthalenesulfonic acid), organic phosphonic acids (e.g., phenylphosphonic acid) and organic carboxylic acids (e.g., benzoic acid, coumalic acid, malic acid), and organic acid chlorides (e.g., naphthalenesulfonyl chloride, benzenesulfonyl chloride). Further, the foregoing solution can be admixed with yellow dyes so as to improve on the tone reproduction of a presensitized plate according to the present invention.

The suitable dry coverage of the high molecular compound is in the range of from 2 to 100 mg/m², preferably from 5 to 50 mg/m². When the dry coverage is less than 2 mg/m², the effect obtained is insufficient. Also, the dry coverage more than 100 mg/m² cannot produce satisfactory effect.

### [3] Positive Working Photosensitive Layer

As a positive working photosensitive composition used for forming a positive working photosensitive layer on the foregoing aluminum support, which has undergone the hydrophilic treatment, or which has undergone not only the hydrophilic treatment but also the treatment with an acidic aqueous solution, or which is further coated with an interlayer, any of photosensitive compositions can be employed so far as the composition can change its solubility or swellability in a developer by exposure to light.

The representatives of such compositions are illustrated below, but they should not be construed as limiting on or determinative of the scope of this invention.

### Photosensitive Compounds

As examples of a photosensitive compound which can constitute a positive working photosensitive composition, mention may be made of o-quinonediazide compounds. The representatives of o-quinonediazide compounds are o-naphthoquinonediazide compounds. Suitable o-naphthoquinonediazide compounds are the esters prepared from 1,2-diazonaphthoquinonesulfonic acid chloride and pyrogallol-acetone resins as described in JP-B-43-28403 (the term "JP-B" as used herein means an "examined Japanese patent publication").

Other suitable o-quinonediazide compounds are the esters prepared from 1,2-diazonaphthoquinonesulfonic acid chloride and phenol-formaldehyde resins described in U.S. Patents 3,046,120 and 3,188,210.

In addition, many other useful o-naphtoquinonediazide compounds are known by disclosure in patents. For instance, the compounds which can be used favorably are those disclosed in JP-A-47-5303, JP-A-48-63802, JP-A-48-63803, JP-A-48-96575, JP-A-49-38701, JP-A-48-13354, JP-B-37-18015, JP-B-41-11222, JP-B-45-9610, JP-B-49-17481, JP-A-5-11444, JP-A-5-19477, JP-A-5-19478, JP-A-5-107755, U.S. Patents 2,797,213, 3,454,400, 3,544,323, 3,573,917, 3,674,495 and 3,785,825, GB Patents 1,227,602, 1,251,345, 1,267,005, 1,329,888 and 1,330,932, and German Patent 854,890.

Also, the o-naphthoquinonediazide compounds prepared by the reaction of polyhydroxy compounds having molecular weight of 1,000 or below with 1,2-diazonaphthoquinone sulfonic acid chloride compound can be used as still other o-quinonediazide compounds. Examples of such a compound include those described in JP-A-51-139402, JP-A-58-150948, JP-A-58-203434, JP-A-59-165053, JP-A-60-121445, JP-A-60-134235, JP-A-60-163043, JP-A-61-118744, JP-A-62-10645, JP-A-62-10646, JP-A-62-153950, JP-A-62-178562, JP-A-64-76047, and U.S. Patents 3,102,809, 3,126,281, 3,130,047, 3,148,983, 3,184,310, 3,188,210 and 4,639,406.

In preparing those o-naphthoquinonediazide compounds, it is desirable that 0.2 to 1.2 equivalents, preferably 0.3 to 1.0 equivalents, of 1,2-diazonaphthoquinonesulfonic acid chloride be allowed to react with the hydroxyl groups of a polyhydroxy compound. As 1,2-diazonaphthoquinonesulfonic acid chloride, 1,2-diazonaphthoquinone-5-sulfonic acid chloride is preferred. However, 1,2-diazonaphthoquinone-4-sulfonic acid chloride may also be used. The thus prepared o-naphthoquinonediazide compound is a mixture of compounds differing in position and amount of the 1,2-diazonaphthoquinonesulfonate groups introduced. In this mixture, it is desirable that the compound corresponding to conversion of all hydroxyl groups of the starting polyhydroxy compound into 1,2-diazonaphthoquinonesulfonate groups (completely esterified compound) be present in a proportion of at least 5 mole %, preferably from 20 to 99 mole %.

Besides o-naphthoquinonediazide compounds, the polymer compounds having o-nitrocarbinol ester groups described in JP-B-52-2696, the pyridinium group-containing compounds (described, e.g., in JP-A-4-365049) and diazonium group-containing compounds (described, e.g., in JP-A-5-249664, JP-A-6-83047, JP-A-6-324495 and JP-A-7-72621) can be used as other positive working photosensitive compounds.
Further, the combination of a compound capable of generating an acid by photolysis with a compound having a acid-decomposable-C-O-C- or -C-O-Si- group (as described in JP-A-4-121748 or JP-A-4-365043) can be employed. Examples of a compound having the acid-decomposable group, which can be used in combination with a compound capable of generating an acid by photolysis, include the acetal or O, N-acetal compounds (JP-A-48-89003), the ortho ester or amidoacetal compounds (JP-A-51-120714), the polymers having acetal or ketal groups in their main chain (JP-A-53-133429), the enol ether compounds (JP-A-55-12995, JP-A-4-19748, and JP-A-6-230574), the N-acyliminocarbon compounds (JP-A-55-126236), the polymers having ortho ester groups in their main chain (JP-A-56-17345), the silyl ester group-containing polymers (JP-A-60-10247) and the silyl ether compounds (JP-A-60-37549, JP-A-60-121446, JP-A-63-236028, JP-A-63-236029, and JP-A-63-276046). The suitable proportion of such a positive working photosensitive compound (including the combinations as recited above) in the present photosensitive composition is generally from 10 to 50 % by weight, preferably from 15 to 40 % by weight.

### Binder

Although the o-quinonediazide compound may be a sole constituent of a photosensitive layer, it is desirable that the photosensitive layer be formed using an o-quinonediazide compound together with a binder such as a resin soluble in aqueous alkali. Examples of the resin soluble in aqueous alkali include a novolak resin having such a property. Specifically, those novolak resins include a phenol-formaldehyde resin and cresol-formaldehyde resins (e.g., m-cresol-formaldehyde resin, p-cresol-formaldehyde resin, m-cresol/p-cresol mixture-formaldehyde resin, and phenol/cresol mixture-formaldehyde resin wherein the cresol may be m-cresol, p-cresol, o-cresol or m-cresol/p-cresol/o-cresol mixture). It is desirable for these alkali-soluble high molecular compounds to have a weight average molecular weight in the range of 500 to 100,000.

Besides those novolak resins, resol type phenol resins are suitable for the binder. As for the phenol resins of resol type, phenol/cresol mixture-formaldehyde resins wherein the cresol may be m-cresol, p-cresol, o-cresol or m-cresol/p-cresol/o-cresol mixture are used advantageously. In particular, the phenol resins described in JP-A-61-217034 are preferred over others.

Further, various other alkali-soluble high molecular compounds, such as a phenol-modified xylene resin, a poly(hydroxystyrene), a poly(halohydroxystyrene), the acrylic resin having phenolic hydroxyl groups as disclosed in JP-A-51-34711, the sulfonamido group-containing vinyl resins and urethane resins described in JP-A-2-866 and vinyl resins having the constitutional units described, e.g., in JP-A-7-28244, JP-A-7-36184, JP-A-7-36185, JP-A-7-248628, JP-A-7-261394 and JP-A-7-333839, can be used in the photosensitive layer. As for the vinyl resins, those preferred in particular are film forming resins which have, as a polymerizing component, at least one alkali-soluble group containing monomer selected from the following families (1) to (4):

The family (1) consists of aromatic hydroxyl group-containing acrylamides, methacrylamide, acrylic esters and methacrylic esters, and hydroxystyrenes. Examples thereof include N-(4-hydroxyphenyl)acrylamide, N-(4-hydroxyphenyl)methacrylamide, o-, m- or p-hydroxystyrene, o- or m-bromo-p-hydroxystyrene, o- or m-chloro-p-hydroxystyrene, o-, m- or p-hydroxyphenylacrylate, and o-, m- or p-hydroxyphenylmethacrylate.

The family (2) consists of unsaturated carboxylic acids. Examples thereof include acrylic acid, methacrylic acid, maleic acid, maleic anhydride and the half ester thereof, itaconic acid, itaconic anhydride and the half ester thereof.

The family (3) consists of unsaturated sulfonamides. Examples thereof include aminosulfonyl group-containing acrylamides, methacrylamides, acrylic esters and methacrylic esters, such as N-(o-aminosulfonylphenyl)acrylamide, N-(m-aminosulfonylphenyl)acrylamide, N-(p-aminosulfonylphenyl)acrylamide, N-[1-(3-aminosulfonyl)naphthyl]acrylamide, N-(2-aminosulfonylethyl)acrylamide, N-(o-aminosulfonylphenyl)methacrylamide, N-(m-aminosulfonylphenyl)methacrylamide, N-(p-aminosulfonylphenyl)methacrylamide, N-[1-(3-aminosulfonyl)naphthyl]methacrylamide, N-(2-aminosulfonylethyl)methacrylamide, o-aminosulfonylphenyl acrylate, m-aminosulfonylphenyl acrylate, p-aminosulfonylphenyl acrylate, 1-(3-aminosulfonylphenylnaphthyl)acrylate, o-aminosulfonylphenyl methacrylate, m-aminosulfonylphenyl methacrylate, p-aminosulfonylphenyl methacrylate and 1-(3-aminosulfonylphenylnaphthyl)methacrylate.

The family (4) consists of phenylsulfonylacrylamides and phenylsulfonylmethacrylamides, including substituted ones such as tosylacrylamide and tosylmethacrylamide.

Furthermore, film forming resins obtained by copolymerizing the alkali-soluble group containing monomers as recited above and other monomers selected from the following families (5) to (14) can be used to advantage:

The family (5) consists of aliphatic hydroxyl group-containing acrylic and methacrylic esters. Examples thereof include 2-hydroxyethyl acrylate and 2-hydroxyethyl methacrylate.

The family (6) consists of unsubstituted and substituted acrylic esters. Examples thereof include methyl acrylate, ethyl acrylate, propyl acrylate, butyl acrylate, amyl acrylate, hexyl acrylate, cyclohexyl acrylate, octyl acrylate, phenyl acrylate, benzyl acrylate, 2-chloroethyl acrylate, 4-hydroxybutyl acrylate, glycidyl acrylate and N-dimethylaminoethyl acrylate.

The family (7) consists of unsubstituted and substituted methacrylic esters. Examples thereof include methyl methacrylate, ethyl methacrylate, propyl methacrylate, butyl methacrylate, amyl methacrylate, hexyl methacrylate, cyclohexyl methacrylate, octyl methacrylate, phenyl methacrylate, benzyl methacrylate, 2-chloroethyl methacrylate, 4-hydroxybutyl methacrylate, glycidyl methacrylate and N-dimethylaminoethyl methacrylate.

The family (8) consists of acrylamides and methacrylamides. Examples thereof include acrylamide, methacrylamide, N-methylolacrylamide, N-methylolmethacrylamide, N-ethylacrylamide, N-ethylmethacrylamide, N-hexylacrylamide, N-hexylmethacrylamide, N-cyclohexylacrylamide, N-cyclohexylmethacrylamide, N-hydroxyethylacrylamide, N-hydroxyethylmethacrylamide, N-phenylacrylamide, N-phenylmethacrylamide, N-benzylacrylamide, N-benzylmethacrylamide, N-nitrophenylacrylamide, N-nitrophenylmethacrylamide, N-ethyl-N-phenylacrylamide and N-ethyl-N-phenylmethacrylamide.

The family (9) consists of vinyl ethers. Examples thereof include ethyl vinyl ether, 2-chloroethyl vinyl ether, hydroxyethyl vinyl ether, propyl vinyl ether, butyl vinyl ether, octyl vinyl ether and phenyl vinyl ether.

The family (10) consists of vinyl esters. Examples thereof include vinyl acetate, vinyl chloroacetate, vinyl butyrate and vinyl benzoate.

The family (11) consists of styrenes. Examples thereof include styrene, α-methylstyrene, methylstyrene and chloromethylstyrene.

The family (12) consists of vinylketones. Examples thereof include methylvinylketone, ethylvinylketone, propylvinylketone and phenylvinylketone.

The family (13) consists of olefins. Examples thereof include ethylene, propylene, isobutylene, butadiene and isoprene.

The family (14) consists of N-vinylpyrrolidone, N-vinylcarbazole, 4-vinylpyridine, acrylonitrile, methacrylonitrile and like.

It is desirable for those alkali-soluble high molecular compounds to have a weight average molecular weight ranging from 500 to 500,000.

The alkali-soluble high molecular compounds as recited above may be used alone or in combination of two or more thereof. The suitable proportion of such alkali-soluble high molecular compound(s) in the photosensitive composition is not more than 80 % by weight, preferably from 30 to 80 % by weight, more preferably from 50 to 70 % by weight. When the proportion is in such a range, those compounds can produce favorable results in the way of developability and impression capacity.

In addition, as described in U.S. Patent 4,123,279, it is desirable from the viewpoint of improving the ink receptivity in the image area that the foregoing alkali-soluble high molecular compounds be used in combination with condensation products of C₃₋₈ alkyl substituted phenols and formaldehyde, such as t-butylphenol-formaldehyde resin and octylphenol-formaldehyde resin, or o-naphthoquinonediazide sulfonic acid esters of these condensation products (e.g., those described in JP-A-61-243446).

### Development Accelerator

For the purpose of heightening the sensitivity and improving the developability, it is desirable to add a cyclic acid anhydride, a phenol and/or an organic acid to the photosensitive composition.

Examples of cyclic acid anhydrides which can be used for the foregoing purpose include phthalic anhydride, tetrahydrophthalic anhydride, hexahydrophthalic anhydride, 3,6-endoxy-Δ⁴-tetrahydrophthalic anhydride, tetrachlorophthalic anhydride, maleic anhydride, chloromaleic anhydride, α-phenylmaleic anhydride, succinic anhydride and pyromellitic anhydride, as described in U.S. Patent 4,115,128.

Examples of phenols which can be used for the foregoing purpose include bisphenol A, p-nitrophenol, p-ethoxyphenol, 2,4,4'-trihydroxybenzophenone, 2,3,4-trihydroxybenzophenone, 4-hydroxybenzophenone, 4,4',4"-trihydroxy-triphenylmethane and 4,4',3",4"-tetrahydroxy-3,5,3',5'-tetramethyltriphenylmethane.

Examples of organic acids which can be added for the foregoing purpose include those described, e.g., in JP-A-60-88942 and JP-A-2-96755, such as sulfonic acids, sulfinic acids, alkylsulfuric acids, phosphonic acids, phosphinic acids, phosphates and carboxylates. More specifically, the acids are p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluylic acid, 3,4-dimethoxybenzoic acid, phthalic acid, terephthalic acid, 1,4-cyclohexene-2,2-dicarboxylic acid, erucic acid, lauric acid, n-undecanoic acid, ascorbic acid and so on.

The proportion of the cyclic acid anhydride, phenol and organic acid in a photosensitive composition used in the present invention is preferably from 0.05 to 15 % by weight, more preferably from 0.1 to 5 % by weight.

### Development Stabilizer

To a photosensitive composition used in the present invention, the nonionic surfactants as described in JP-A-62-251740 and JP-A-4-68355 and the amphoteric surfactants as described in JP-A-59-121044 and JP-A-4-13149 can be added for the purpose of enhancing development consistency under variable conditions (in other words, for extending development latitude).

Examples of the nonionic surfactant include sorbitan tristearate, sorbitan monopalmitate, sorbitan trioleate, stearic acid monoglyceride, polyoxyethylene sorbitan monooleate and polyoxyethylene nonylphenyl ether.

Examples of the amphoteric surfactant include alkyldi(aminoethyl) glycines, alkylpolyaminoethylglycine hydrochlorides, 2-alkyl-N-carboxyethyl-N-hydroxyethylimidazolinium betaines, amphoteric surfactants of N-tetradecyl-N,N-betaine type, (e.g., Amogen K, trade name, produced by Daiich Kogyo Co., Ltd.), and amphoteric surfactants of alkylimidazoline type (e.g., Lebon 15, trade name, produced by Sanyo Chemical Industries, Ltd.).

The proportion of the aforementioned nonionic and amphoteric surfactants in the photosensitive composition ranges preferably from 0.05 to 15 % by weight, more preferably from 0.1 to 5 % by weight.

### Printing-out Agent, Dyes and so forth

The photosensitive compositions used in the present invention can contain printing-out agents for producing a visual image just after exposure, dyes as an image coloring agent, fillers and so forth can be added. As examples of such dyes, mention may be made of the basic dyes described in JP-A-5-313359, which are salts of a cation having a basic dye skeleton and an organic anion having a sulfonic acid group as the sole exchange group and having at least 10 carbon atoms and 1 to 3 hydroxyl groups. The suitable proportion of dyes added is from 0.2 to 5 % by weight to the total photosensitive composition.

To photosensitive compositions used in the present invention can further be added compounds which can generate photolysis products capable of interacting with the dyes described in JP-A-5-313359 to change their tones, such as the o-naphthoquinonediazide-4-sulfonic acid halogenides described in JP-A-50-36209 (corresponding to U.S. Patent 3,969,118), the trihalomethyl-2-pyrones and the halomethyltriazines described in JP-A-53-36223 (corresponding to U.S. Patent 4,160,671), the various o-naphthoquinonediazide compounds described in JP-A-55-62444 (corresponding to U.S. Patent 2,038,801) and the 2-trihalomethyl-5-aryl-1,3,4-oxadiazole compounds described in JP-A-55-77742 (corresponding to U.S. Patent 4,279,982). These compounds can be used alone or as a mixture of two or more thereof. Of these compounds, those absorbing light at 400 nm may be used as yellow dyes explained below.

Besides the dyes described in the above-cited gazette JP-A-5-313359, other dyes can be used as image coloring agent. In addition to salt-forming organic dyes, oil-soluble dyes and basic dyes are suitably used as image coloring agent. Examples of such dyes include Oil Green BG, Oil Blue BOS and Oil Blue #603 (products of Orient Chemical Industry Co., Ltd.), Victoria Pure Blue BOH, Victoria Pure Blue NAPS and Ethyl Violet 6HNSPAS (products of Hodogaya Chemical Co., Ltd.), Rhodamine B (CI45170B), Malachite Green (CI42000) and Methylene Blue (CI52015).

Furthermore, the yellow dyes which are represented by the following formula [I], [II] or [III] and meet the requirement that the absorbance at 417 nm is at least 70 % of the absorbance at 436 nm can be added to the photosensitive composition: 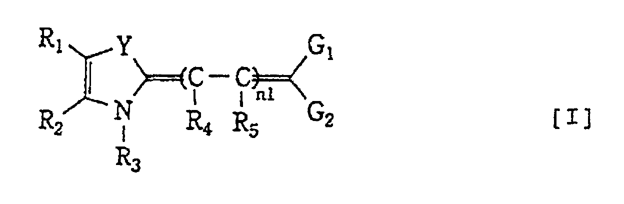 (wherein R₁ and R₂ each independently are a hydrogen atom, an alkyl group having 1 to 10 carbon atoms, an aryl group or an alkenyl group, or R₁ and R₂ combine with each other to complete a ring; R₃, R₄ and R₅ each independently are a hydrogen atom or an alkyl group having 1 to 10 carbon atoms; G₁ and G₂ each independently are an alkoxycarbonyl group, an aryloxycarbonyl group, an acyl group, an arylcarbonyl group, an alkylthio group, an arylthio group, an alkylsulfonyl group, an arylsulfonyl group or a fluoroalkylsulfonyl group, or they combine with each other to complete a ring; and further, at least one of these substituents R₁, R₂, R₃, R₄, R₅, G₁ and G₂ has at least one of sulfonic acid group, a carboxyl group, a sulfonamido group, an imido group, an N-sulfonylamido group, a phenolic hydroxyl group, a sulfonimido group, a metal salt of any of these groups, and an inorganic or organic ammonium salt of any of these groups; Y is a divalent atomic group of formula -O-, -S-, -NR- (wherein R is a hydrogen atom, an alkyl group or an aryl group), -Se-, -C(CH₃)₂- or -CH=CH-; and n₁ is 0 or 1) 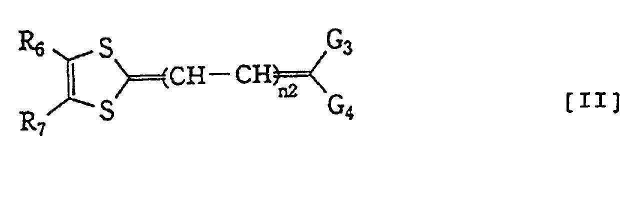 (wherein R₆ and R₇ each independently are a hydrogen atom, an alkyl group, a substituted alkyl group, an aryl group, a substituted aryl group, a heterocyclic group, a substituted heterocyclic group, an allyl group or a substituted allyl group, or they combine and form a ring together with the carbon atoms to which they are attached; n₂ is 0, 1 or 2; G₃ and G₄ each independently are a hydrogen atom, a cyano group, an alkoxycarbonyl group, a substituted alkoxycarbonyl group, an aryloxycarbonyl group, a substituted aryloxycarbonyl group, an acyl group, a substituted acyl group, an arylcarbonyl group, a substituted arylcarbonyl group, an alkylthio group, an arylthio group, an alkylsulfonyl group, an arylsulfonyl group or a fluoroalkylsulfonyl group, provided that the case of G₃=G₄= hydrogen is excluded, or G₃ and G₄ combine and form a ring constituted of nonmetal atoms together with the carbon atoms they are attached to; and further, at least one of these substituents R₆, R₇, G₃ and G₄ has at least one of sulfonic acid group, a carboxyl group, a sulfonamido group, an imido group, an N-sulfonylamido group, a phenolic hydroxyl group, a sulfonimido group, a metal salt of any of these groups, and an inorganic or organic ammonium salt of any of these groups) 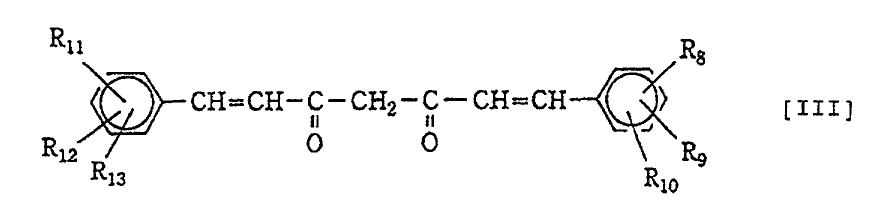 (R₈, R₉, R₁₀, R₁₁, R₁₂ and R₁₃, which may be the same or different, each represent a hydrogen atom, an alkyl group, a substituted alkyl group, an aryl group, a substituted aryl group, an alkoxyl group, a hydroxyl group, an acyl group, a cyano group, an alkoxycarbonyl group, an aryloxycarbonyl group, a nitro group, a carboxyl group, a chlorine atom or a bromine atom).

### Formation of Positive Working Photosensitive Layer, and so forth

The foregoing ingredients of each photosensitive composition are dissolved in an appropriate solvent, and coated on the aluminum support to form a positive working photosensitive layer.

Examples of a solvent usable therein include γ-butyrolactone, ethylene dichloride, cyclohexanone, methyl ethyl ketone, ethylene glycol monomethyl ether, ethylene glycol monoethyl ether, 2-methoxyethylacetate, 1-methoxy-2-propanol, 1-methoxy-2-propylacetate, toluene, ethyl acetate, methyl lactate, ethyl lactate, dimethyl sulfoxide, dimethylacetamide, dimethylformamide, water, N-methylpyrrolidone, tetrahydrofurfuryl alcohol, acetone, diacetone alcohol, methanol, ethanol, isopropanol and diethylene glycol dimethyl ether. These solvents can be used alone or as a mixture of two or more thereof. The concentration of ingredients (solids) of the photosensitive composition in the coating solution is preferably from 2 to 50 % by weight. The suitable coverage of a photosensitive composition is from 0.5 to 4.0 g/m². When the coverage is less than 0.5 g/m², the impression capacity deteriorates; while, when it is more than 4.0 g/m², the sensitivity decreases.

The formation of a photosensitive layer, e.g., a method of coating a solution of photosensitive composition on the support, can be effected using hitherto known various methods.

To the photosensitive composition can be added surfactant, e.g., the fluorine-containing surfactants as described in JP-A-62-170950 for the purpose of improving the coatability. The amount of the surfactant is preferably from 0.01 to 1 % by weight, more preferably from 0.05 to 0.5 % by weight, to the total photosensitive composition.

The lithographic printing plate thus obtained can provide printed matter faithful to an original picture film, but this printed matter has a loss of sharpness, the cause of which is traceable to exposure, and gives a bad impression of a lack of suppleness. The loss of sharpness in the printed matter can be reduced using a method of roughening the surface of a photosensitive layer formed in the aforementioned manner. For instance, there is known the method described in JP-A-61-258255 wherein particles having a size of several µm are added to a solution of photosensitive composition and the resulting solution is coated on a substrate. However, this method has a slight improvement on the loss of sharpness, and no effect on dissipation of the impression of a lack of suppleness.

On the other hand, not only the loss of sharpness but also the impression of a lack of suppleness can be improved by adopting the method of attaching a roughening substance to the surface of a photosensitive layer, as described, e.g., in JP-A-50-125805, JP-B-57-6582, JP-B-61-28986 and JP-B-62-62337. Further, both the loss of sharpness and the impression of a lack of suppleness are more improved by adopting the method of incorporating in a matte layer a light absorbing agent which can absorb light in the wavelength region where the photosensitive component has spectral sensitivities, as described in JP-B-55-30619. In addition, this method can provide printed matter of good quality even when the original picture film used is a picture film having a screen ruling of 300 lines or more per 2,54 cm (inch) or a picture film obtained by FM screening, which is more liable to cause a loss of sharpness and the impression of a lack of suppleness than a picture film having a screen ruling of 175 lines per 2,54cm (inch). The suitable fine pattern thus provided on the photosensitive layer surface of a presensitized plate is as follows: The height of each coated spot in the fine pattern is from 1 to 40 µm, preferably from 2 to 20 µm, the size (width) thereof is from 10 to 10,000 µm, preferably from 20 to 200 µm, and the number of coated spots is from 1 to 1,000 per mm², preferably from 5 to 500 per mm².

### [4] Development-Processing

The development-processing of a presensitized plate according to the present invention is illustrated below.

### Exposure

After imagewise exposure, the present presensitized plate is subjected to development-processing. Examples of a light source of actinic rays used for imagewise exposure include a carbon arc lamp, a mercury lamp, a metal halide lamp, a xenon lamp, a tungsten lamp and a chemical lamp. Examples of a radiation which can be used include electron beams, X-ray, ion beams and far infrared rays. In addition, g-line, i-line, Deep UV light and high density energy beams (laser beams) can be employed. Examples of the laser beams include He-Ne laser, argon laser, krypton laser, He-Cd laser, KrF excimer laser, semiconductor laser and YAG laser.

### Developer

The developer which can be suitably used for the present presensitized plates is an aqueous alkaline solution substantially containing no organic solvents. More specifically, such a suitable developer is an aqueous solution in which sodium silicate, potassium silicate, NaOH, KOH, LiOH, sodium tertiary phosphate, sodium secondary phosphate, ammonium tertiary phosphate, ammonium secondary phosphate, sodium metasilicate, sodium carbonate, sodium hydrogencarbonate or potassium carbonate is dissolved, or aqueous ammonia. Moreover, it is preferable for the present invention to use a developer which comprises (a) at least one nonreducing saccharide and (b) at least one base and ranges in pH from 9.0 to 13.5.

Now, the aforementioned developer is described in detail. Additionally, unless otherwise indicated, the term "developer" used in the description is intended to include both a developer which is used at the beginning of development and a replenisher which is used in the course of development.

### Nonreducing Saccharide and Base

As mentioned above, the preferred developer is characterized by comprising at least one compound selected from nonreducing saccharides and at least one base as main components and ranging in pH from 9.0 to 13.5.

Such nonreducing saccharides are saccharides which contain neither free aldehyde groups nor free ketone groups, and so which have no reducing properties. These saccharides are classified as trehalose type oligosaccharides wherein the reducing groups are combined in pairs, glycosides produced by combining the reducing groups of saccharides with nonsaccharides, or glycitols produced by reducing saccharides by hydrogenation, and any of them can be suitably employed. Examples of the trehalose type oligosaccharide include saccharose and trehalose; examples of the glycoside include an alkylglycoside, a phenolglycoside and a mustard oil glycoside; and examples of the glycitol include D,L-arabitol, ribitol, xylitol, D,L-sorbitol, D,L-mannitol, D,L-iditol, D,L-talitol, dulcitol and allodulcitol. In addition, maltitol produced by hydrogenation of disaccharide and reduction products obtained by hydrogenation of oligosaccharide can be favorably used. Of these nonreducing saccharides, glycitols and saccharose are preferred over the others. In particular, D-sorbitol, saccharose and hydrogenated oligosaccharides are used to advantage because they perform a buffering action in a proper pH region and their prices are low.

Those nonreducing saccharides can be used alone or as a mixture of two or more thereof, and it is desirable for them to have a concentration ranging preferably from 0.1 to 30 % by weight, more preferably from 1 to 20 % by weight, in the developer. When the concentration of nonreducing saccharides is below that range, sufficient buffering effect cannot be produced; while the concentration high than 30 % by weight makes it difficult to concentrate the developer highly and as a result, causes a rise in the cost.

In contrast, the developer containing a reducing saccharide and a base in combination has a drawback that brown coloration and gradual drop in pH are caused with a lapse of time, and thereby the developability is lowered.

The bases used in combination with nonreducing saccharides are hitherto known alkali agents. Examples thereof include inorganic alkali agents, such as sodium hydroxide, potassium hydroxide, lithium hydroxide, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium hydrogencarbonate, potassium hydrogencarbonate, ammonium hydrogencarbonate, sodium borate, potassium borate and ammonium borate, and organic alkali agents, such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

These alkali agents can be used alone or as a mixture of two or more thereof. Of the alkali agents recited above, sodium hydroxide and potassium hydroxide are preferred over the others. This is because these hydroxides enables the pH adjustment in a wide pH region by controlling their proportions to nonreducing saccharides. In addition, sodium tertiary phosphate, potassium tertiary phosphate, sodium carbonate and potassium carbonate are favorable because they themselves have a buffering function.

These alkali agents are added in such an amount that the pH of the developer be generally in the range of 9.0 to 13.5, and the amount to be added can be determined depending on the intended pH value, and the species and the amount of nonreducing saccharides used in combination. The pH of the developer is preferably in the range of from 10.0 to 13.2.

Further, the developer can be used in combination with an alkaline buffering solution comprising a strong acid and a weak acid other than saccharide. The salt prepared from a strong acid and a weak acid may be added into the developer, or a strong acid and a weak acid may be added separately into the developer. The weak acids suitable for such a buffering solution are compounds having a pKa of from 10.0 to 13.2. These compounds can be selected from the weak acids described, e.g., in IONISATION CONSTANTS OF ORGANIC ACIDS IN AQUEOUS SOLUTION published by Pergamon Press. Specifically, those weak acids include alcohols, such as 2,2,3,3-tetrafluoropropanol-1 (pKa 12.74), trifluoroethanol (pKa 12.37) and trichloroethanol (pKa 12.24); aldehydes, such as pyridine-2-aldehyde (pKa 12.68) and pyridine-4-aldehyde (pKa 12.05); phenolic hydroxyl group-containing compounds, such as salicylic acid (pKa 13.0), 3-hydroxy-2-naphthoic acid (pKa 12.84), catechol (pKa 12.6), gallic acid (pKa 12.4), sulfosalicylic acid (pKa 11.7), 3,4-dihydroxysulfonic acid (pKa 12.2), 3,4-dihydroxybenzoic acid (pKa 11.94), 1,2,4-trihydroxybenzene (pKa 11.82), hydroquinone (pKa 11.56), pyrogallol (pKa 11.34), o-cresol (pKa 10.33), resorcinol (pKa 11.27), p-cresol (pKa 10.27) and m-cresol (pKa 10.09); oximes, such as 2-butanonoxime (pKa 12.45), acetoxime (pKa 12.42), 1,2-cycloheptanonedioxime (pKa 12.3), 2-hydroxybenzaldehydeoxime (pKa 12.10), dimethylglyoxime (pKa 11.9), ethanediamidedioxime (pKa 11.37) and acetophenoneoxime (pKa 11.35); nucleic acid related substances, such as adenosine (pKa 7.2.56), inosine (pKa 12.5), guanine (pKa 12.3), cytosine (pKa 12.2), hypoxanthine (12.1) and xanthine (11.9); and other weak acids, such as diethylaminomethylphosphonic acid (pKa 12.32), 1-amino-3,3,3-trifluorobenzoic acid (pKa 12.29), isopropylidenediphosphonic acid (pKa 12.10), 1,1-ethylidenediphosphonic acid (pKa 11.54), 1-hydroxy-1,1-ethylienediphosphonic acid (pKa 11.52), benzimidazole (pKa 12.86), thiobenzamide (pKa 12.8), picolyl thioamide (pKa 12.55) and barbituric acid (pKa 12.5). Of these weak acids, sulfosalicylic acid and salicylic acid are preferred over the others.

Examples of the strong base which can be preferably used in combination with the weak acid include sodium hydroxide, ammonium hydroxide, potassium hydroxide and lithium hydroxide.

These alkali agents can be used alone or as a mixture of two or more thereof. The foregoing various alkali agents are used in appropriate combination and concentration to adjust the pH to the desired range.

### Surfactant

To the developer, various surfactants and organic solvents can be added, if needed, for enhancing the developability, dispersing developer dregs and elevating the ink receptivity in the image area of a printing plate. The surfactants suitable for these purposes include anionic, cationic, nonionic and amphoteric surfactants.

Suitable examples of the nonionic surfactant include polyoxyethylene alkyl ethers, polyoxyethylene alkylphenyl ethers, polyoxyethylene polystyrylphenyl ethers, polyoxyethylenepolyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanolamides, N,N-bis-2-hydroxyalkylamines, polyoxyethylene alkylamines, triethanolamine fatty acid esters and trialkylamine oxides; examples of the anionic surfactant include salts of fatty acids, salts of abietic acid, salts of hydroxyalkanesulfonic acids, salts of alkanesulfonic acids, salts of dialkylsulfosuccinates, salts of straight-chain alkylbenzenesulfonic acids, salts of branched alkylbenzenesulfonic acids, salts of alkylnaphthalenesulfonic acids, salts of alkylphenoxypolyoxyethylenepropylsulfonic acids, salts of polyoxyethylene alkylsulfophenyl ethers, sodium salt of N-methyl-N-oleyltaurine, disodium salt of N-alkylsulfosuccinic acid monoamides, salts of petroleum sulfonic acid, sulfated tallow oil, salts of fatty acid alkyl ester sulfates, salts of alkylsulfates, salts of polyoxyethylene alkyl ether sulfates, salts of fatty acid monoglyceride sulfates, salts of polyoxyethylene alkylphenyl ether sulfates, salts of polyoxyethylene styrylphenyl ether sulfates, salts of alkylphosphates, salts of polyoxyethylene alkyl ether phosphates, salts of polyoxyethylene alkylphenyl ether phosphates, partial saponification products of styrene/maleic anhydride copolymer, partial saponification products of olefin/maleic anhydride copolymer and naphthalenesulfonate-formaldehyde condensates; examples of the cationic surfactant inlcude alkylamine salts, quaternary ammonium salts such as tetrabutylammonium bromide, polyoxyethylene alkylamine salts and polyethylene polyamine derivatives; and examples of the amphoteric surfactant include carboxybetaines, aminocarboxylic acids, sulfobetaines, aminosulfates and imidazolines.

The term "polyoxyethylene" used in the above-recited surfactants can be replaced by a polyoxyalkylene such as polyoxymethylene, polyoxypropylene or polyoxybutylene, and the compounds resulted from the replacement can be included in suitable surfactants.

Further, fluorine-containing surfactants, such as surfactants having perfluoroalkyl groups, are more preferable for the foregoing purposes. Examples of such a fluorine-containing surfactant include anionic surfactants such as perfluoroalkylcarboxylates, perfluoroalkylsulfonates and perfluoroalkylphosphates, amphoteric surfactants such as perfluoroalkylbetaines, cationic surfactants such as perfluoroalkyltrimethylammonium salts, and nonionic surfactants such as perfluoroalkylamine oxides, perfluoroalkylethylene oxide adducts, oligomers containing a perfluoroalkyl group and a hydrophilic group, oligomers containing a perfluoroalkyl group and a lipophilic group, oligomers containing a perfluoroalkyl group, a hydrophilic group and a lipophilic group, and urethanes containing a perfluoroalkyl group and a lipophilic group.

The surfactants recited above can be used alone or as a mixture of two or more thereof, and added to the developer in a proportion of 0.001 to 10 % by weight, preferably from 0.01 to 5 % by weight.

### Development Stabilizer

Various development stabilizer can be used in the developer. Suitable examples of the development stabilizer, as described in JP-A-6-282079, include polyethylene glycol adducts of glycitols, tetraalkylammonium salts such as tetrabutylammonium hydroxide, phosphonium salts such as tetrabutylphosphonium bromide, and iodonium salts such as diphenyliodonium chloride.

Also, the anionic surfactants and the amphoteric ones described in JP-A-50-51324, the water-soluble cationic polymers described in JP-A-55-95946 and the water-soluble amphoteric polyelectrolytes described in JP-A-56-142528 can be used as development stabilizer.

Further, examples of the development stabilizer include the alkylene glycol-added organic boron compounds described in JP-A-59-84241, the polyoxyethylene-polyoxypropylene block copolymer type water-soluble surfactants described in JP-A-60-111246, the polyoxyethylene-polyoxypropylene-substituted alkylenediamines described in JP-A-60-129750, the polyethylene glycol having a weight average molecular weight of at least 3,000 described in JP-A-61-215554, the cationic group-attached fluorine-containing surfactants described in JP-A-63-175858, the water-soluble ethylene oxide-added compounds obtained by addition reaction of acids or alcohols with at least 4 moles of ethylene oxide described in JP-A-2-39157, and the water-soluble polyalkyelne compounds.

### Organic Solvent

The developer is substantially free from organic solvents. However, organic solvents can be added, if needed. Such organic solvents are selected from those having solubility of about 10 % by weight or below in water, preferably about 5 % by weight or below. Examples of an organic solvent which can be added include 1-phenylethanol, 2-phenylethanol, 3-phenyl-1-propanol, 4-phenyl-1-butanol, 4-phenyl-2-butanol, 2-phenyl-1-butanol, 2-phenoxyethanol, 2-benzyloxyethanol, o-methoxybenzyl alcohol, m-methoxybenzyl alcohol, p-methoxybenzyl alcohol, benzyl alcohol, cyclohexanol, 2-methylcyclohexanol, 3-methylcyclohexanol, 4-methylcyclohexanol, N-phenylethanolamine and N-phenyldiethanolamine. The expression "substantially free from organic solvents" as used herein signifies that the proportion of organic solvents is not higher than 5 % by weight to the total weight of the working developer. The amount of organic solvents used has a close relation to the amount of surfactants used, and it is desirable that the amount of surfactants used be increased with an increase in the amount of organic solvents used. This is because, if organic solvents are used in a large amount in spite of the use of surfactants in a small amount, the organic solvents cannot be dissolved completely to make it difficult to ensure satisfactory developing properties.

### (Reducing Agent)

Further, a reducing agent can be added to the developer, and thereby the scum on the printing plate can be prevented. In particular, the addition of a reducing agent is effective in developing a negative working presensitized plate containing a light-sensitive diazonium salt compound. Examples of an organic reducing agent suitable for addition to the developer include phenol compounds such as thiosalicylic acid, hydroquinone, Metol, methoxyquinone, resorcin and 2-methylresorcin, and amine compounds such as phenylenediamine and phenylhydrazine. Examples of an inorganic reducing agent preferable for the addition include sodium, potassium and ammonium salts of inorganic acids such as sulfurous acid, hydrogensulfurous acid, phosphorous acid, hydrogenphosphorous acid, dihydrogenphosphorous acid, thiosulfuric acid and dithionous acid. Of these reducing agents, sulfites are superior to the others in scum preventing effect. The proportion of the reducing agent in the working developer is preferably from 0.05 to 5 % by weight.

### Organic Carboxylic Acid

Further, organic carboxylic acids can be added to the developer. The organic carboxylic acids are aliphatic or aromatic carboxylic acids having 6 to 20 carbon atoms. Examples of such an aliphatic carboxylic acid include caproic acid, enanthylic acid, caprylic acid, lauric acid, myristic acid, palmitic acid and stearic acid. In particular, an alkanoic acid having 8 to 12 carbon atoms is preferred over the others. Additionally, the organic carboxylic acid added may also be an unsaturated fatty acid having a double bond in the carbon chain or a fatty acid having a branched carbon chain.

The aromatic carboxylic acid as mentioned above is a compound having a benzene, naphthalene, or anthracene ring each having a carboxyl group as a substituent. Examples thereof include o-chlorobenzoic acid, p-chlorobenzoic acid, o-hydroxybenzoic acid, p-hydroxybenzoic acid, o-aminobenzoic acid, p-aminobenzoic acid, 2,4-dihydroxybenzoic acid, 2,5-dihydroxybenzoic acid, 2,6-dihydroxybenzoic acid, 2,3-dihydroxybenzoic acid, 3,5-dihydroxybenzoic acid, gallic acid, 1-hydroxy-2-naphthoic acid, 3-hydroxy-2-naphthoic acid, 2-hydroxy-1-naphthoic acid, 1-naphthoic acid and 2-naphthoic acid. In particular, hydroxynaphthoic acids are preferred over the others.

For enhancing the solubilities of aliphatic or aromatic carboxylic acids in water, it is desirable that those carboxylic acids be used in the form of sodium, potassium or ammonium salts. The proportion of organic carboxylic acids in the developer has no particular limitation. However, when the proportion thereof is lower than 0.1 % by weight, those carboxylic acids cannot produce sufficient effect; while, when it is higher than 10 % by weight, not only the effect cannot be enhanced but also it is highly probable that they will interfere with dissolution of other additives used together. Therefore, it is desirable for the organic carboxylic acids to be added in a proportion of 0.1 to 10 % by weight, more preferably 0.5 to 4 % by weight, to the working developer.

### Other Additives

Furthermore, the developer may contain antiseptics, coloring agents, thickeners, anti-foaming agents, water softeners and so on, if desired. Examples of a water softener which can be used therein include polyphosphoric acid and sodium, potassium and ammonium salts thereof; aminopolycarboxylic acids, such as ethylenediaminetetraacetic acid, diethylenetriaminepentaacetic acid, triethylenetetraminehexaacetic acid, hydroxyethylethylenediaminetriacetic acid, nitrilotriacetic acid, 1,2-diaminocyclohexanetetraacetic acid and 1,3-diamino-2-propanoltetraacetic acid, and sodium, potassium and ammonium salts thereof; aminotri(methylenephosphonic acid), ethylenediaminotetra(methylenephosphonic acid), diethylenetriaminepenta(methylenephosphonic acid), triethylenetetraminehexa(methylenephosphonic acid), hydroxyethylethylenediaminetri(methylenephosphonic acid) and 1-hydroxyethane-1,1-diphosphonic acid, and their sodium, potassium and ammonium salts.

The optimal proportion of the water softener in the developer depends on its chelating power, the hardness of water used and the amount of water used, but it is generally from 0.01 to 5 % by weight, preferably from 0.01 to 0.5 % by weight. When the water softener is added in a proportion below the foregoing range, the intended effect cannot be achieved; while, when the proportion is beyond the foregoing range, bad influences on the image area, such as discoloration, are produced.

The residual component of the developer is water. From the viewpoint of carrying the developer, it is favorable to previously prepare a concentrated liquid developer reduced in water content, compared with the working developer, and dilute the concentrated one with water at the time to use. In this case, it is appropriate for the developer to be concentrated to such an extent that the ingredients present therein cause neither separation nor precipitation.

As another developer suitable for the present presensitized plates, the developer described in JP-A-6-282079 can be employed. This developer is a developer comprising an alkali metal silicate, wherein the SiO₂/M₂O ratio (wherein M is an alkali metal) is from 0.5 to 2.0 by mole, and a water-soluble ethylene oxide-added compound formed by addition reaction of one mole of glycitol having at least 4 hydroxyl groups with at least 5 moles of ethylene oxide. The glycitol used therein is a polyhydric alcohol corresponding to a saccharide whose aldehyde or ketone groups are reduced to be converted into primary or secondary alcohol groups respectively. Examples of such a glycitol include D,L-threitol, erythritol, D,L-arabitol, ribitol, xylitol, D,L-sorbitol, D,L-mannitol, D,L-iditol, D,L-talitol, dulcitol and allodulcitol, and further include di-, tri-, tetra-, penta- and hexaglycerines formed by condensation of glycitol. The foregoing water-soluble ethylene oxide-added compound includes compounds produced by adding at least 5 moles of ethylene oxide to one mole of each of the glycitols recited above. Further, these ethylene oxide-added compounds may undergo block copolymerization with propylene oxide to such an extent that the solubilities of the resulting compounds are in an allowable range. Those ethylene oxide-added compounds may be used alone or as mixture of two or more thereof.

It is desirable for the aforementioned water-soluble ethylene oxide-added compounds to be added in a proportion of 0.001 to 5 % by weight, preferably 0.001 to 2 % by weight, to the working developer.

To the developer of the foregoing type, various surfactants and organic solvents as recited hereinbefore can further be added for the purpose of accelerating the development, dispersing the developer dregs and enhancing the ink receptivity in the image area of a printing plate.

### (Development and After-treatment)

The presensitized plate developed with the developer having a composition as mentioned above is subjected to after-treatments with wash water, a rinsing solution containing a surfactant and so on, a finisher containing gum arabic or a starch derivative as a main component, and/or a protective gum solution. For the after-treatment of the present presensitized plates, various combinations of those treatments can be used.

In recent years, automatic developing machines for presensitized plates have been widely used in the platemaking and graphic arts industry with the intention of rationalizing and standardizing the platemaking operations. In general, such an automatic developing machine is composed of a development section and an after-treatment section, and equipped with an apparatus for conveying a presensitized plate, a tank and a spraying device for each processing solution. Therein, each of processing solutions pumped up is sprayed from a spray nozzle onto an exposed presensitized plate which is being conveyed horizontally, thereby achieving development and after-treatment. Quite recently, there have been known the method of developing a presensitized plate while dipping it in a processing tank filled with a processing solution and conveying it with guide rollers installed in the tank or so on, and the method of washing an developed presensitized plate by supplying thereto wash water in a prescribed small amount and reusing the wash water waste as a diluent for an undiluted developer.

In such an automatic processing, each processing step can be performed while a replenisher for each processing solution is supplemented depending on the processing quantity, the operation time and so on. On the other hand, the way of processing with a substantially unused processing solution, or the so-called throwaway processing solution, can be adopted.

The lithographic printing plate made through the processing as mentioned above is mounted in an offset printing machine, and used for printing a great number of copies.

The present invention will now be illustrated in more detail by reference to the following examples and comparative examples.

In each example, as mentioned hereinbefore, the amount of sodium silicate attached to a substrate [B] after treatment with an aqueous solution of sodium silicate (hydrophilic treatment) is determined as the amount of Si atoms (expressed in mg/m²) using an X-ray fluorescence spectrometer and a calibration curve procedure. More specifically, RIX 3000 made by Rigaku Corporation is used as X-ray fluorescence spectrometer under the following condition, and the amount of Si atoms is determined from the peak height of Si-Kα spectrum;

| | |
|---|---|
| Apparatus | RIX 3000 made by Rigaku Corporation |
| X-ray tube | Rh |
| Spectrum measured | Si-Kα |
| Tube voltage | 50 kV |
| Tube current | 50 mA |
| Slit | COARSE |
| Analyzing crystal | RX4 |
| Detector | F-PC |
| Analysis area | 30 mmφ |
| Peak position (2θ) | 144.75 deg. |
| Background (26) | 140.70 deg., 146.85 deg. |
| Integration time | 80 sec/sample |

Additionally, the amount of Si atoms as shown in each of the following examples is the value corrected by subtracting the amount of Si atoms contained in the aluminum support from the measured value.

### EXAMPLES 1 TO 5

The surface of a 0.24 mm-thick JIS A1050 aluminum plate was grained with a nylon brush and an aqueous suspension of 400 mesh pumice, and thoroughly rinsed with water. Then, etching was effected by dipping the plate in a 10 wt% NaOH aqueous solution kept at 70°C for 60 seconds, and washed with running water. Further, the etched plate was rinsed with a 20 % by weight aqueous HNO₃ for neutralization, and washed with water. Then, the resulting plate underwent an electrolytic surface-roughening treatment using sine wave alternating current under a potential of 12.7 V in a quantity of electricity of 200 Coulomb/cm² at the anode in a 1 % by weight aqueous solution of nitric acid. Its surface roughness measured was 0.55 µm (expressed in Ra). Subsequently, the plate was desmutted by being soaked in a 30 % by weight aqueous solution of sulfuric acid at 55°C for 2 minutes. Thereafter, the plate was subjected to an anodic oxidation treatment using a 20 % by weight aqueous solution of sulfuric acid under a current density of 14 A/dm² so that the anodically oxidized film of 2.5 g/m² was formed, followed by washing treatment. Thus, a substrate [A] was prepared.

The thus prepared substrate [A] was treated with a 3 % by weight aqueous solution of sodium silicate for 10 seconds at 20°C, and then washed, thereby preparing a substrate [B]. The amount of sodium silicate attached to the substrate [B] was 2.9 mg/m² in terms of Si atom.

On the surface of the substrate [B], the following solution comprising an high molecular compound as shown hereinbefore in Table 1 was coated and dried for 15 seconds at 80°C to form an interlayer. The dry coverage of each high molecular compound was 15 mg/m².

### Solution of High Molecular Compound for Formation of Interlayer

| | |
|---|---|
| High molecular compound as shown in Table 1 | 0.3 g |
| Methanol | 100 g |
| Water | 1 g |

Then, a photosensitive layer was provided on the thus treated substrate by applying the following photosensitive solution [A] to the interlayer. The dry coverage of the photosensitive layer was 1.3 g/m². Further, in order to shorten the vacuum contact time, a matte layer was formed on the photosensitive layer in accordance with the method described in JP-B-61-28986. Thus, a presensitized plate was prepared.

### Photosensitive Solution A

| | |
|---|---|
| Esterification product prepared from 1,2-diazonaphthoquinone-5-sulfonyl chloride and pyrogallol-acetone resin (described in Example 1 of U.S. Patent 3,635,709) | 0.8 g |

| Binder | |
|---|---|
| Novolak I | 1.5 g |
| Novolak II | 0.2 g |
| Resin III other than novolak | 0.4 g |
| p-n-Octylphenol-formaldehyde resin (described in U.S. Patent 4,123,279) | 0.02 g |
| Naphthoquinone-1,2-diazido-4-sulfonic acid chloride | 0.01 g |
| Tetrahydrophthalic anhydride | 0.02 g |
| Benzoic acid | 0.02 g |
| Pyrogallol | 0.05 g |
| 4-[p-N,N-Bis(ethoxycarbonylmethyl)amino-phenyl]-2,6-bis(trichloromethyl)-s-triazine (hereinafter referred to as triazine A) | 0.07 g |
| Victoria Pure Blue BOH having 1-naphthalene-sulfonate ion as a counter ion (produced by Hodogaya Chemical Co., Ltd.) | 0.045 g |
| F-176 PF (fluorine-containing surfactant, produced by Dai-Nippon Ink & Chemicals, Inc.) | 0.01 g |
| Methyl ethyl ketone | 15 g |
| 1-Methoxy-2-propanol | 10 g |

### Novolak I

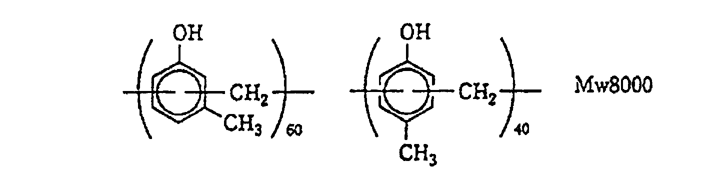

### Novolak II

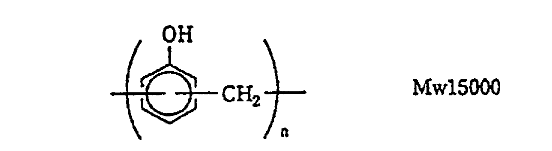

### Resin III other than novolak

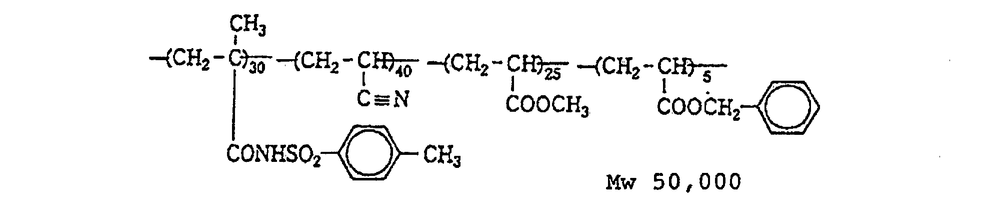

Each of the thus prepared presensitized plates was exposed imagewise for 1 minute by means of a 3 kW metal halide lamp placed at a distance of 1 m, and developed for 12 seconds at 30°C by means of a PS Processor 900VR made by Fuji Photo Film Co., Ltd., wherein the following Developer A or Developer B was used as a developer.

### Developer A:

| | |
|---|---|
| D-sorbitol | 5.1 parts by weight |
| Sodium hydroxide | 1.1 parts by weight |
| Triethanolamine-ethylene oxide adduct (30 moles) | 0.03 parts by weight |
| Water | 93.8 parts by weight |

### Developer B:

| | |
|---|---|
| Aqueous solution of sodium silicate having [SiO₂]/[Na₂O] ratio of 1.2 by mole and containing 1.4 % by weight of SiO₂ | 100 parts by weight |
| Ethylenediamine-ethylene oxide adduct (30 moles) | 0.03 parts by weight |

The thus developed presensitized plates were each examined for impression capacity, scumproof property and extent of whitening, and further as to whether they each gave rise to dregs and sludge in the developer used. The examination results obtained are shown in Table 2.

Additionally, the above properties were evaluated as follows:

### Impression Capacity

The printing operation was continued with a printing machine Sprint (made by Komori Printing Machine K.K.) until each printing plate could not provide a normally printed sheet any longer. The impression capacity of each printing plate was evaluated in terms of the number of normally printed sheets obtained by this printing operation. Thus, the greater the number of printed sheets, the higher the impression capacity.

### Scumproof Property

After 1,000 sheets of printed matter were obtained using each printing plate mounted in a printing machine SOR-M (made by Heidelberg A.G.), the printing machine was stopped, and each printing plate was detached therefrom and allowed to stand for 30 minutes. Then, the printing plate was mounted again in the printing machine, and the printing operation was resumed to make 100 sheets of printed matter. At this time, how the printing ink was cleared away from the non-image area of each printing plate was observed, and the scumproof property was evaluated as follows;
A ··· The ink is quickly cleared away (The scumming is hardly caused).
B ··· The ink is somewhat slowly cleared away.
C ··· The ink is slowly cleared away (The scumming is easily caused).

### Extent of Whitening

After the development, both solid area and non-image area were deleted with a deletion fluid RP-2 (produced by Fuji Photo Film Co., Ltd.) and then washed. The extent of whitening at the time of development was evaluated by visual observation of the thus deleted solid and non-image areas according to the following criterion;
A ··· There is slight difference in color between the deleted solid area and the non-image area.
B ··· The non-image area is whiter than the deleted solid area, but the difference in color is not so great.
C ··· The non-image area is clearly white, compared with the deleted solid area.

### Dregs and Sludge in Developer

Each printing plate was processed in an area of 10 m² per 1 liter of Developer A or B, and the resulting developer was examined for the extent of dregs and sludge generated therein, thereby judging the extent of dissolution of the oxidized layer in the alkaline developer.
A ··· Neither dregs nor sludge is generated.
B ··· Generation of dregs and sludge is observed, but the quantity thereof is not large.
C ··· Dregs and sludge are generated in a large quantity.

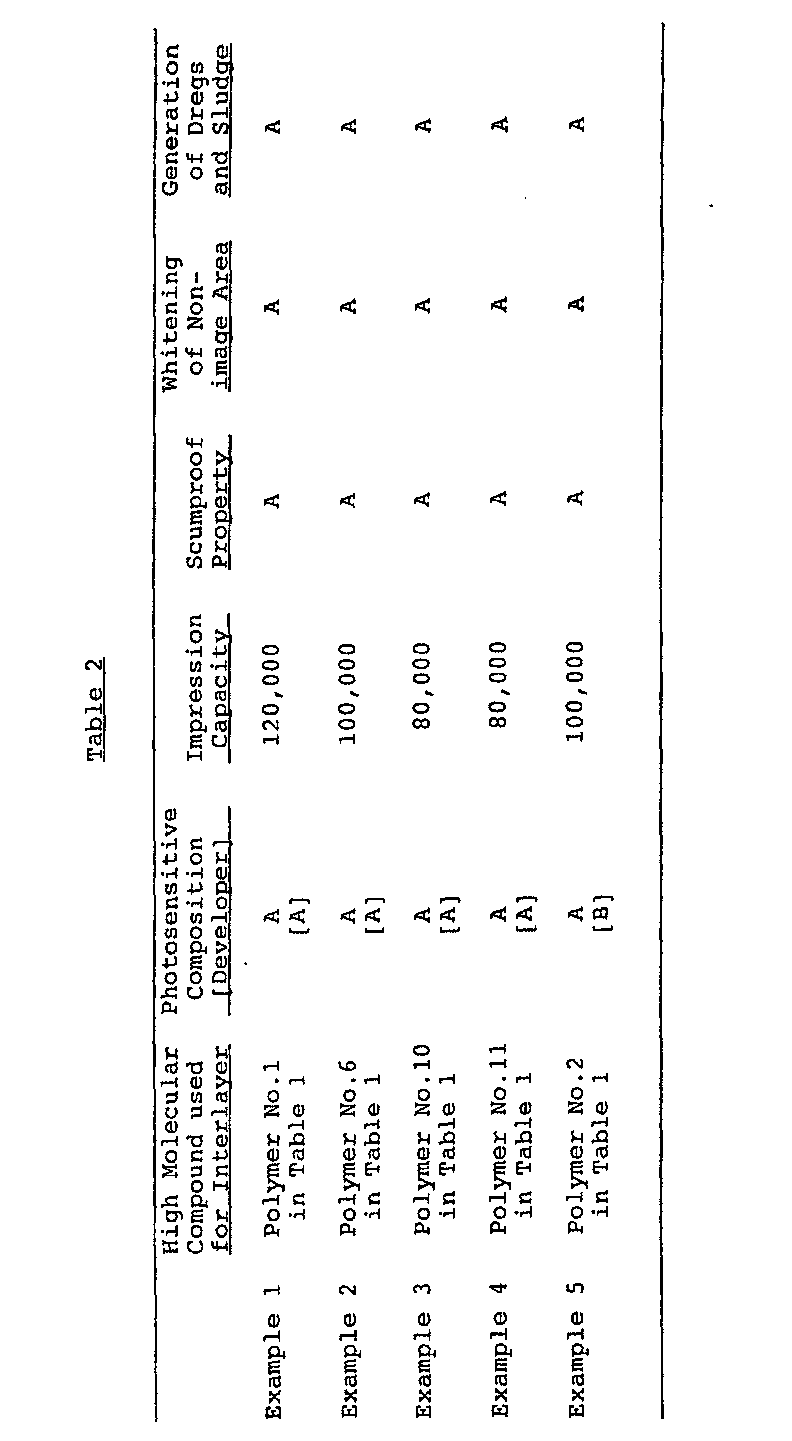

### EXAMPLE 6

Another lithographic printing plate was prepared in the same manner as in Example 1, except that the solution of high molecular compound for formation of an interlayer was not applied to the surface of the substrate [A] (in other words, the photosensitive solution [A] was coated directly on the surface of the substrate [B] previously treated with the solution of sodium silicate).

The impression capacity and scumproof property of the thus made lithographic printing plate were examined by the same measurements as carried out in Example 1. As a result, it was found that the impression capacity was 70,000 sheets and the scumproof property was satisfactory.

### EXAMPLE 7

Five lithographic printing plates were made in the same process as adopted in Example 2, except that four of them underwent the treatment with the aqueous sodium silicate for preparing the substrate [B] under different temperatures set forth in Table 3 respectively and one of them didn't undergo the treatment with the aqueous sodium silicate.

The amount of Si atoms attached to each of the substrates [B] which were in advance treated with the aqueous sodium silicate under the different temperatures respectively was measured, and the impression capacity and scumproof property of each of the lithographic printing plates made under the aforementioned conditions were evaluated by the same measurements as in Example 2. The results thus obtained are shown in Table 3.

As can be seen from the experimental results shown in Table 3, the amount of Si atoms attached to the substrate [B] was increased beyond the limits specified by the present invention in Experiment No. (Comparative Example 1) to result in the lowering of impression capacity; while, in Experiment No. 6 (Comparative Example 2) which corresponds to the case where the substrate [A] undergoes no treatment with sodium silicate, so that the substrate [B] has no Si atoms attached thereto, the scumproof property was unsatisfactory, the non-image area was whitened and the developer generated dregs and sludge.

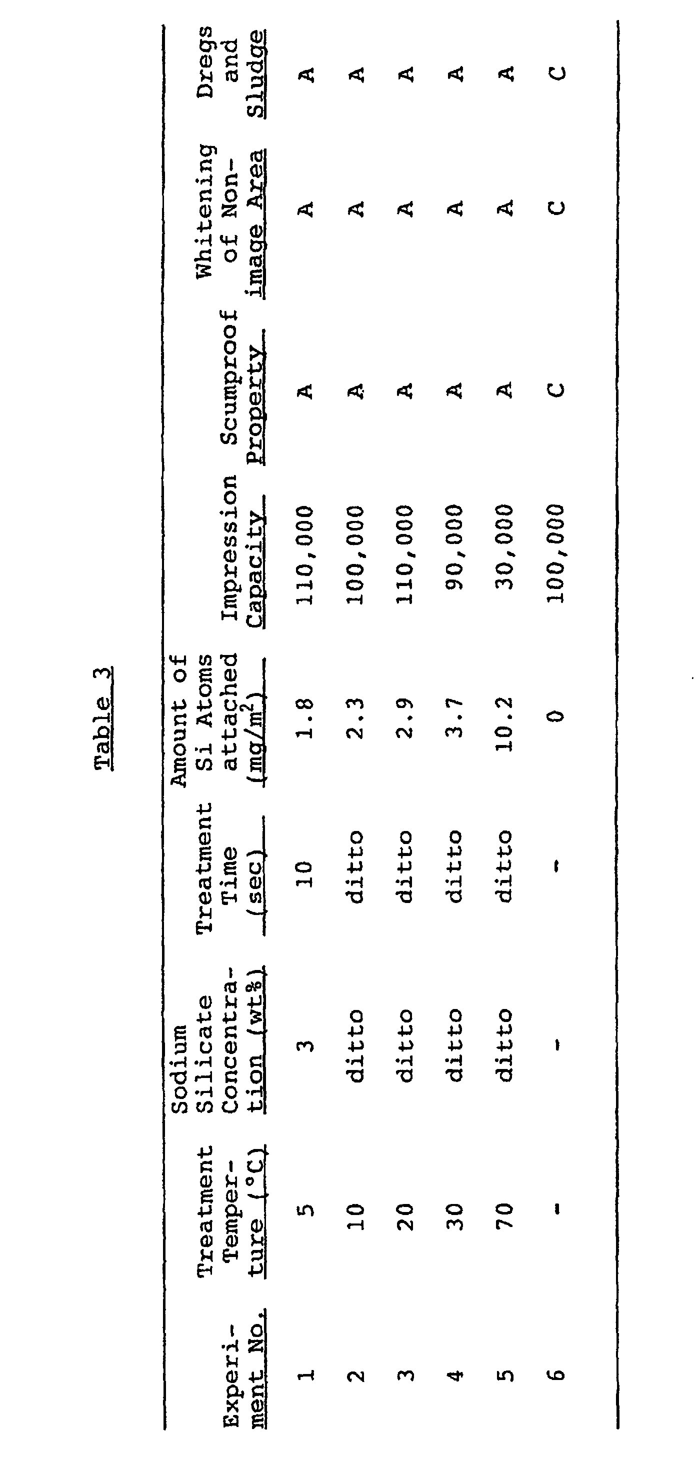

### EXAMPLE 8

Three lithographic printing plates were made in the same process as adopted in Example 3, except that they underwent the treatment with the aqueous sodium silicate for preparing the substrate [B] under different temperatures set forth in Table 4 respectively and, after the treatment with the aqueous sodium silicate, each of the substrates [B] prepared was further treated with an aqueous solution having HNO₃ concentration of 0.1 % by weight before being coated with the solution of high molecular compound to form the interlayer.

The amount of Si atoms attached to each of the substrates [B], which were in advance treated with the aqueous sodium silicate under the different temperatures respectively and further with the aqueous solution of nitric acid, was measured. Also, the impression capacity and scumproof property of each of the lithographic printing plates made under the aforementioned conditions were evaluated by the same measurements as in Example 3. The results thus obtained are shown in Table 4.

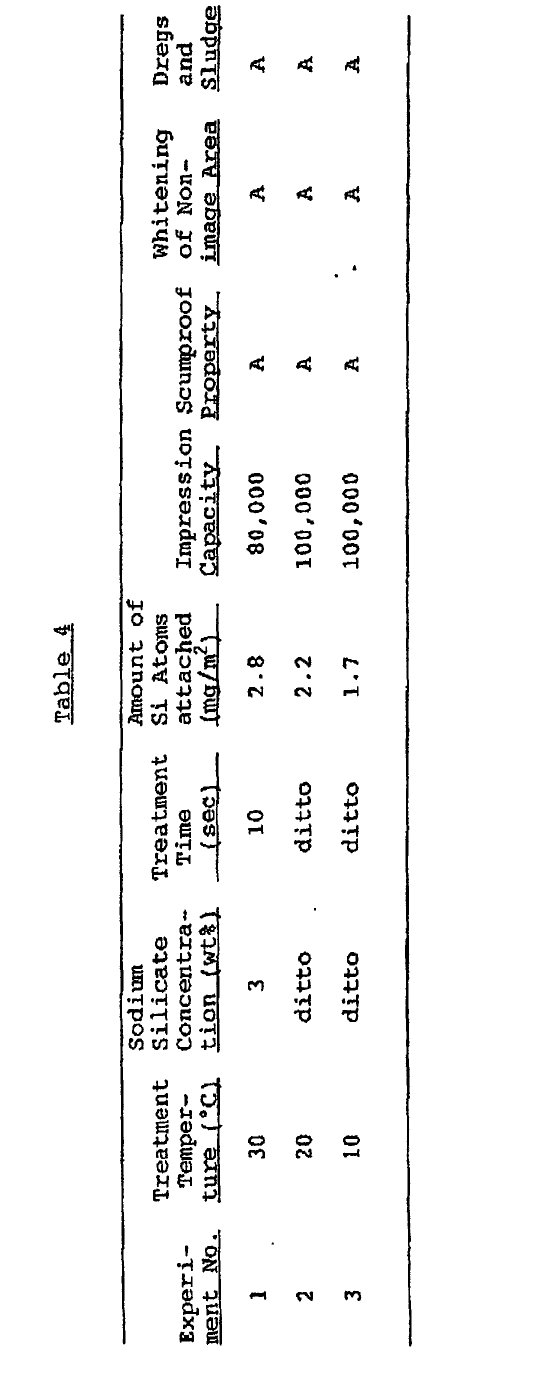

### EXAMPLE 9

Five lithographic printing plates were made in the same process as adopted in Example 4, except that the substrates [B] used therein were in advance treated respectively with aqueous solutions containing sodium silicate in the different concentrations set forth in Table 5 at a temperature of 30°C.

The amount of Si atoms attached to each of the substrates [B] which were in advance treated respectively with the solutions having different sodium silicate concentrations was measured, and the impression capacity and scumproof property of each of the lithographic printing plates made under the aforementioned conditions were evaluated by the same measurements as in Example 4. The results thus obtained are shown in Table 5.

As can be seen from the experimental results shown in Table 5, the amount of Si atoms attached to the substrate [B] was increased beyond the limits specified by the present invention in Experiment No. 5 to result in the lowering of impression capacity. In other words, the embodiment of Experiment No.5 falls under a comparative experiment.

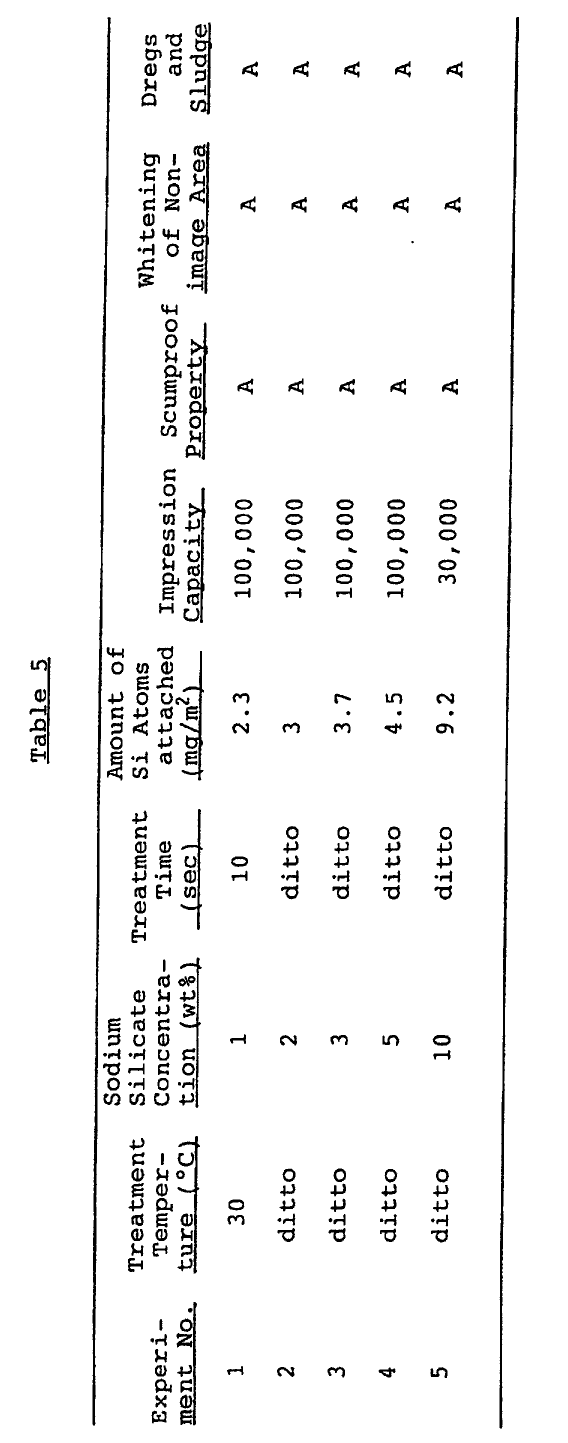

### EXAMPLE 10

Five lithographic printing plates were made in the same process as adopted in Example 5, except that the previous treatment for their respective substrates [B] with the aqueous solution of sodium silicate was performed for different periods of time as set forth in Table 6 at a temperature of 30°C.

The amount of Si atoms attached to each of the substrates [B] previously treated with the solution of sodium silicate for different periods of time respectively was measured, and the impression capacity and scumproof property of each of the lithographic printing plates made under the aforementioned conditions were evaluated by the same measurements as in Example 5. The results thus obtained are shown in Table 6.

As can be seen from the experimental results shown in Table 6, the amount of Si atoms attached to the substrate [B] was increased beyond the limits specified by the present invention in Experiment No. 5 to result in the lowering of impression capacity. In other words, the embodiment of Experiment No.5 falls under a comparative experiment.

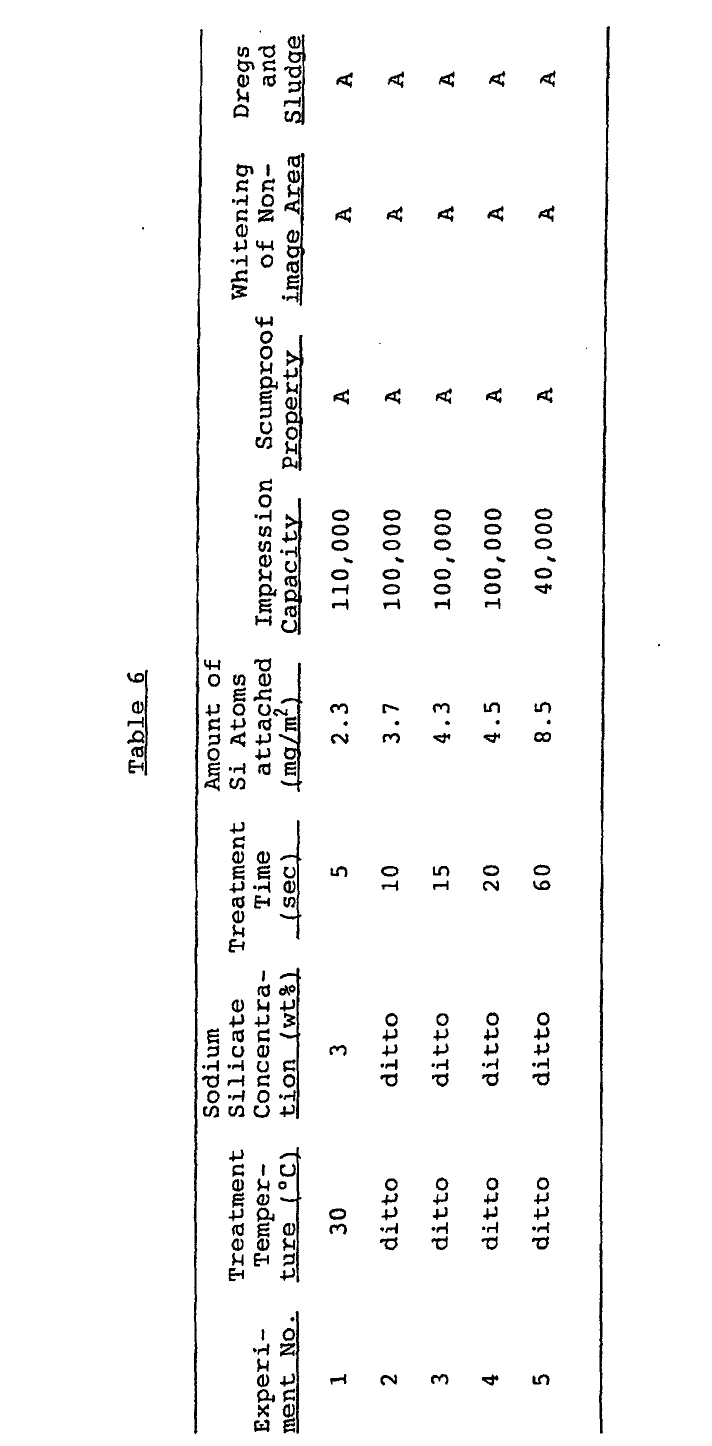

### Examples 11 TO 16

Each of the following interlayer-forming solutions respectively containing high molecular compounds set forth in Table 7 was applied to the same substrate [B] as used in Example 1, and dried for 15 seconds at 80°C. The dry coverage of each high molecular compound was 15 mg/m².

### Solution of high molecular compound for formation of interlayer

| | |
|---|---|
| High molecular compound as shown in Table 7 | 0.3 g |
| Methanol | 90 g |
| Ethanol | 10 g |
| Water | 1 g |

Then, a photosensitive layer was provided on the thus treated substrate by applying the following photosensitive solution [B] or [C] to the interlayer. The dry coverage of the photosensitive layer was 1.8 g/m². Further, in order to shorten the vacuum contact time, a matte layer was formed on the photosensitive layer in accordance with the method described in JP-B-61-28986. Thus, a presensitized plate was prepared.

### Photosensitive Solution B

| | |
|---|---|
| Esterification product prepared from 1,2-diazonaphthoquinone-5-sulfonyl chloride and pyrogallol-acetone resin (described in Example 1 of U.S. Patent 3,635,709) | 0.9 g |

| Binder | |
|---|---|
| Novolak IV | 1.60 g |
| Novolak V | 0.3 g |
| p-n-Octylphenol-formaldehyde resin | 0.02 g |
| (described in U.S. Patent 4,123,279) | |
| Naphthoquinone-1,2-diazido-4-sulfonic acid chloride | 0.01 g |
| Tetrahydrophthalic anhydride | 0.02 g |
| Benzoic acid | 0.02 g |
| Pyrogallol | 0.05 g |
| Triazine A | 0.07 g |
| Victoria Pure Blue BOH having 1-naphthalene-sulfonate ion as a counter ion (produced by Hodogaya Chemical Co., Ltd.) | 0.10 g |
| F-176 PF (fluorine-containing surfactant, produced by Dai-Nippon Ink & Chemicals, Inc.) | 0.06 g |
| Methyl ethyl ketone | 12.0 g |

### Novolak IV

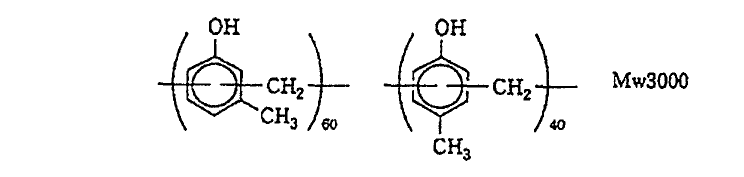

### Novolak V

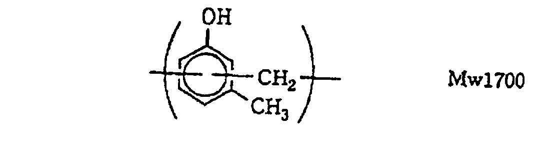

### Photosensitive Solution C

| | |
|---|---|
| Esterification product prepared from 1,2-diazonaphthoquinone-5-sulfonyl chloride and 2,3,4-trihydroxybenzophenone (esterification degree: 90 %) | 0.6 g |
| Copolymer of N-(p-aminosulfonylphenyl)-methacrylamide, acrylonitrile and methyl methacrylate (45:30:25 by mole, Mw=75,000) | 1.7 g |
| Novolak IV | 0.7 g |
| Tetrahydrophthalic anhydride | 0.05 g |
| Triazine A | 0.07 g |
| Victoria Pure Blue BOH having 1-naphthalene-sulfonate ion as a counter ion (produced by Hodogaya Chemical Co., Ltd.) | 0.05 g |
| F-176 PF (fluorine-containing surfactant, produced by Dai-Nippon Ink & Chemicals, Inc.) | 0.06 g |
| γ-butyrolactone | 8.0 g |
| Methyl ethyl ketone | 12.0 g |
| 1-Methoxy-2-propanol | 10.0 g |

The thus prepared presensitized plates were each subjected to imagewise exposure in the same manner as in Example 1, and developed with Developer A or B under the same conditions as in Examples 1 to 5.

The thus made lithographic printing plates were each examined for impression capacity and scumproof property by carrying out the same measurements respectively as in Example 1. The results obtained are shown in Table 7.

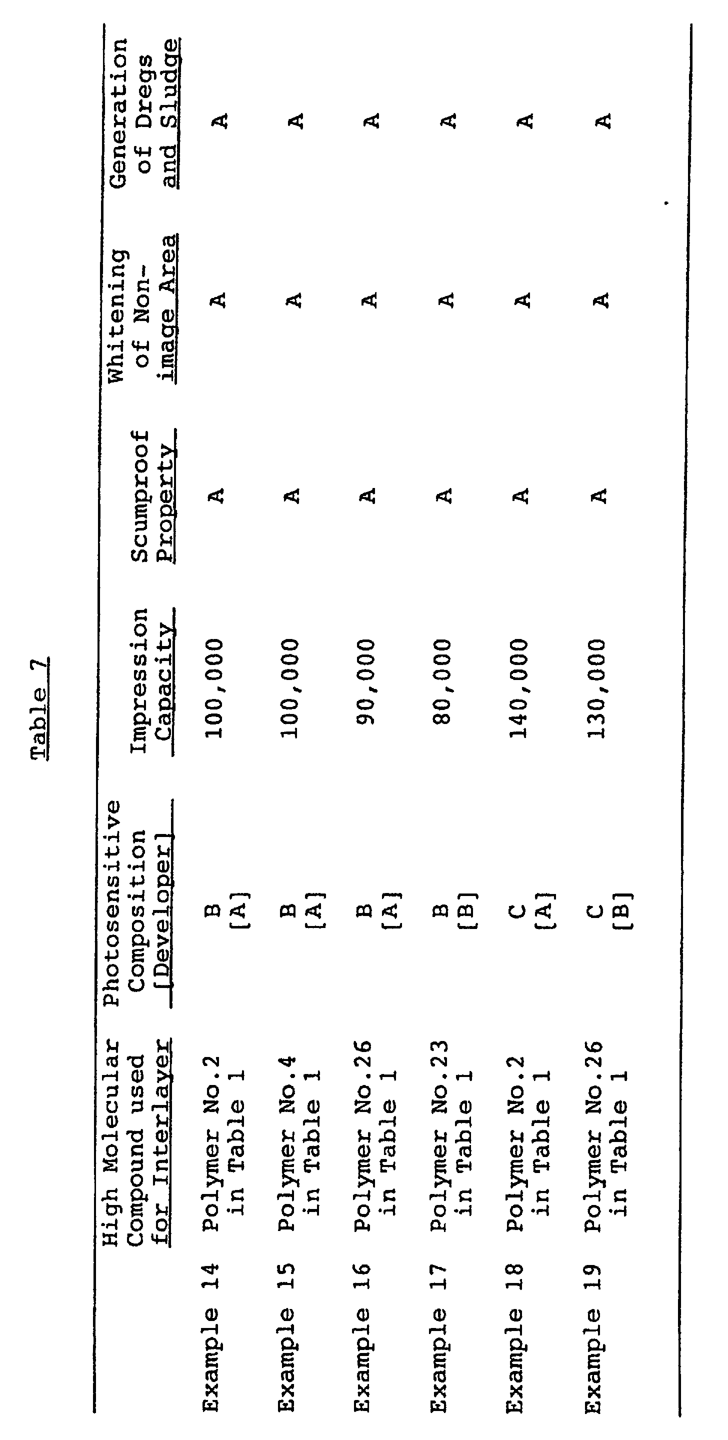

In accordance with the present invention can be provided a positive working presensitized plate which ensures not only sufficient impression capacity and satisfactory scumproof property, but also the prevention of whitening in the non-image area and the inhibition of dregs and sludge generation in the developer. Further, even when it is developed with an alkali metal silicate-free developer, the present presensitized plate can ensure excellent properties as mentioned above. Furthermore, in accordance with the present invention, the hydrophilic treatment for an aluminum support is carried out under mild conditions and the aluminum silicate attached to the aluminum support is reduced in quantity. Therefore, the hydrophilic treatment according to the present invention has an economic advantage over the conventional hydrophilic treatment with an alkali metal silicate.

While the invention has been described in detail and with reference to specific embodiments thereof, it will be apparent to one skilled in the art that various changes and modifications can be made therein without departing from the scope of the claims.

## Claims

1. A positive working photosensitive lithographic printing plate comprising an aluminum support and a positive working photosensitive layer, wherein the amount of Si atoms attached to said aluminum support is in the range of 0.1 to 8 mg/m².

2. The positive working photosensitive lithographic printing plate of claim 1, wherein an interlayer comprising a high molecular compound having acid group-containing constitutional units is provided on said aluminum support and said positive working photosensitive layer is provided on the interlayer.

3. The positive working photosensitive lithographic printing plate of claim 2, wherein said high molecular compound comprises not only acid group-containing constitutional units but also onium group-containing constitutional units.

4. The positive working photosensitive lithographic printing plate of claim 2, wherein said high molecular compound has 20 mol% or more of acid group-containing constitutional units and 1 mol% or more of onium group-containing constitutional units.

5. The positive working photosensitive lithographic printing plate of claim 2, wherein said high molecular compound has a weight-average molecular weight of 500 to 2,000,000.

6. The positive working photosensitive lithographic printing plate of claim 2, wherein said interlayer has a dry coverage of 2 to 100 mg/m².

7. The positive working photosensitive lithographic printing plate of claim 1, wherein said positive working photosensitive layer contains an o-quinonediazide compound.

## Patentansprüche

1. Positiv arbeitende, fotoempfindliche, lithografische Druckplatte, die einen Aluminiumträger und eine positiv arbeitende, fotoempfindliche Schicht umfasst, worin die Menge an Si-Atomen, die an dem Aluminiumträger anhaften, im Bereich von 0,1-8 mg/m² liegt.

2. Positiv arbeitende, fotoempfindliche, lithografische Druckplatte gemäss Anspruch 1, worin eine Zwischenschicht, die eine hochmolekulare Verbindung mit säuregruppenhaltigen Aufbaueinheiten umfasst, auf dem Aluminiumträger bereitgestellt ist, und die positiv arbeitende, fotoempfindliche Schicht ist auf der Zwischenschicht bereitgestellt.

3. Positiv arbeitende, fotoempfindliche, lithografische Druckplatte gemäss Anspruch 2, worin die hochmolekulare Verbindung nicht nur säuregruppenhaltige Aufbaueinheiten umfasst, sondern ferner oniumgruppenhaltige Aufbaueinheiten.

4. Positiv arbeitende, fotoempfindliche, lithografische Druckplatte gemäss Anspruch 2, worin die hochmolekulare Verbindung 20 mol-% oder mehr säuregruppenhaltige Aufbaueinheiten und 1 mol-% oder mehr oniumgruppenhaltige Aufbaueinheiten aufweist.

5. Positiv arbeitende, fotoempfindliche, lithografische Druckplatte gemäss Anspruch 2, worin die hochmolekulare Verbindung ein Gewichtsdurchschnitts-Molekulargewicht von 500-2.000.000 besitzt.

6. Positiv arbeitende, fotoempfindliche, lithografische Druckplatte gemäss Anspruch 2, worin die Zwischenschicht in einer Trockenbedeckung von 2-100 mg/m² vorhanden ist.

7. Positiv arbeitende, fotoempfindliche lithografische Druckplatte gemäss Anspruch 1, worin die positiv arbeitende fotoempfindliche Schicht eine Orthochinondiazidverbindung enthält.

## Revendications

1. Planche d'impression lithographique photosensible à fonctionnement positif, comprenant un support en aluminium et une couche photosensible à fonctionnement positif, dans laquelle la quantité d'atomes de Si fixés audit support en aluminium se trouve dans la plage de 0,1 à 8 mg/m².

2. Planche d'impression lithographique photosensible à fonctionnement positif selon la revendication 1, dans laquelle une couche intermédiaire comprenant un composé à haut poids moléculaire possédant des unités constitutives contenant des groupes acide est prévu sur ledit support en aluminium et dans laquelle ladite couche photosensible à fonctionnement positif est prévue sur la couche intermédiaire.

3. Planche d'impression lithographique photosensible à fonctionnement positif selon la revendication 2, dans laquelle ledit composé à haut poids moléculaire comprend non seulement des unités constitutives contenant des groupes acide, mais aussi des unités constitutives contenant des groupes onium.

4. Planche d'impression lithographique photosensible à fonctionnement positif selon la revendication 2, dans laquelle ledit composé à haut poids moléculaire possède 20 % en mole ou plus d'unités constitutives contenant un groupe acide et 1 % en mole ou plus d'unités constitutives contenant des groupes onium.

5. Planche d'impression lithographique photosensible à fonctionnement positif selon la revendication 2, dans laquelle ledit composé à haut poids moléculaire possède un poids moléculaire moyen en poids de 500 à 2 000 000.

6. Planche d'impression lithographique photosensible à fonctionnement positif selon la revendication 2, dans laquelle ladite couche intermédiaire possède une couverture sèche de 2 à 100 mg/m².

7. Planche d'impression lithographique photosensible à fonctionnement positif selon la revendication 1, dans laquelle ladite couche photosensible à fonctionnement positif contient un composé o-quinonediazide.
